# EUROPÄISCHE PATENTSCHRIFT

(11) **EP 2 478 530 B1**
(45) Veröffentlichungstag und Bekanntmachung des Hinweises auf die Patenterteilung: **19.06.2013**
(21) Anmeldenummer: 10770509.7
(22) Anmeldetag: 14.09.2010
(51) Int. Cl.: H01F 1/00, H01F 41/16, G01R 33/12, B82Y 25/00

(54) **VERFAHREN ZUR HERSTELLUNG EINES ELEKTRISCHEN BAUTEILS UND ELEKTRISCHES BAUTEIL**
METHOD FOR PRODUCING AN ELECTRIC COMPONENT AND ELECTRIC COMPONENT
PROCÉDÉ DE FABRICATION D'UN COMPOSANT ÉLECTRIQUE ET COMPOSANT ÉLECTRIQUE

(30) Priorität: 14.09.2009 DE 102009041096
(43) Veröffentlichungstag der Anmeldung: 25.07.2012
(73) Patentinhaber: MEAS Deutschland GmbH, 44227 Dortmund (DE)
(72) Erfinder: BARTOS, Axel, 45731 Waltrop (DE); VOß, Andreas, 44149 Dortmund (DE)
(74) Vertreter: Tilmann, Max Wilhelm
(86) Internationale Anmeldenummer: PCT/EP2010/005620
(87) Internationale Veröffentlichungsnummer: WO 2011/029629

(56) Entgegenhaltungen:
- WO-A1-2007/044959

## Beschreibung

Die Erfindung betrifft ein Verfahren zur Herstellung eines elektrischen Bauteils mit mindestens zwei elektrischen Kontakten und auf einem Substrat angeordneten Nanopartikeln aus einem elektrisch leitfähigen Material, Nanopartikeln aus einem magnetischen Material und/oder Nanopartikeln aus einem magnetisierbaren Material. Ebenso betrifft die Erfindung ein elektrisches Bauteil.

Aus der Diplomarbeit "Charakterisierung von Cobalt-Nanopartikeln und Untersuchung zur Herstellung granularer Strukturen" von Inga Ennen, erstellt 2003 für die Fakultät für Physik der Universtität Bielefeld, und der Dissertation "Magnetische Nanopartikel als Bausteine für granulare Systeme: Mikrostruktur, Magnetismus und Transporteigenschaften" von Inga Ennen erstellt 2008 für die Fakultät für Physik der Universtität Bielefeld ist es bekannt, Nanopartikel durch Keimbildung, Wachstum, Reifung und Stabilisierung zu bilden (Kapitel 2.1 der Dissertation). Ferner ist es bekannt, zur Herstellung eines granularen Modellsystems Co-Nanopartikel mit einem mittleren Durchmesser von circa 8 nm zu verwenden und diese mittels Aufschleudern oder Dippen auf das Substrat zu übertragen sowie nach dem Entfernen einer organischen Hülle der Nanopartikel die magnetischen Partikelkerne mit einer dünnen Metallschicht abzudecken (vgl. Kapitel 7.1 der Dissertation und die darin enthaltenen weiteren Querverweise auf die Dissertation und die Diplomarbeit). An dieser Vorgehensweise ist insbesondere nachteilig, dass das Erzeugen der Partikelmonolage mittels Aufschleudern oder Dippen erfolgt. Diese Verfahren eignen sich nicht für eine industrielle Herstellung elektrischer Bauteile.

Aus der WO 2007/044959 A1 ist ein Verfahren zur Herstellung eines elektrischen Bauteils mit mindestens zwei elektrischen Kontakten und auf einem Substrat angeordneten Nanopartikeln aus einem magnetischen Material bekannt, bei dem eine mit einer Hülle umgebene Nanopartikel enthalten Tinte mittels eines Druckverfahrens auf das Substrat aufgebracht wird.

Vor diesem Hintergrund liegt der Erfindung die Aufgabe zugrunde, ein Herstellungsverfahren für das eingangs beschriebene elektrische Bauteil vorzuschlagen, das eine industrielle Fertigung derartiger elektrischer Bauteile erlaubt. Ferner soll ein elektrisches Bauteil vorgeschlagen werden, das vielfältig einsetzbar ist.

Diese Aufgabe wird durch das Herstellungsverfahren gemäß Anspruch 1 und das elektrische Bauteil gemäß Anspruch 12 gelöst. Vorteilhafte Ausführungsformen sind in den Unteransprüchen und der hier nachfolgenden Beschreibung wiedergegeben.

Die Erfindung geht von dem Grundgedanken aus, mit einer Hülle umgebene Nanopartikel in eine Flüssigkeit zu geben, um somit eine Tinte zu bilden, die mittels eines Druckverfahrens auf das Substrat aufgebracht werden kann. Druckverfahren, also Verfahren, bei denen eine Tinte auf ein Substrat aufgebracht wird, sind aus anderen technischen Gebieten, insbesondere dem Bedrucken von Papier und Textilien gut bekannt und hinsichtlich ihrer Technologie hinreichend ausgereift, um im industriellen Maßstab eine Tinte auf ein Substrat aufzubringen.

Als Druckverfahren wird insbesondere bevorzugt das aus der Bürotechnik bekannte Tintenstrahldruckverfahren eingesetzt, das zu den so genannten Non Impact Printing (NIP-Verfahren, elektronische Druckverfahren ohne explizite Druckform) gehört.

Als Druckverfahren können aber auch Verfahren eingesetzt werden, die nach dem Flach-, Hoch-, Tief- oder Durchdruckverfahren arbeiten, wie sie in DIN 16500 definiert werden. Bei dem Hochdruckverfahren stehen die Bildstellen der Druckform höher als Nichtbildstellen (zum Beispiel bekannt aus Buchdruck, Flexodruck). Bei dem Flachdruckverfahren liegen die Bildstellen und die Nichtbildstellen der Druckform annähernd auf einer Ebene (zum Beispiel bekannt vom Offsetdruck). Bei dem Tiefdruckverfahren liegen die Bildstellen der Druckform tiefer als Nichtbildstellen. Bei dem Durchdruckverfahren bestehen Bildstellen der Druckform aus einer Schablone auf einem farbdurchlässigen Schablonenträger (Sieb aus Kunststoff- oder Metallfäden), Nichtbildstellen sind farbundurchlässig (zum Beispiel bekannt vom Siebdruck und Risographie). Insbesondere bevorzugt werden direkte Druckverfahren eingesetzt, die dadurch definiert sind, daß das Druckbild direkt von der Druckform auf das Substrat gebracht wird. Deshalb muß das Druckbild seitenverkehrt auf der Druckform angebracht sein. Beispiele für ein direktes Druckverfahren sind der Rakeltiefdruck, der Buchdruck und der Flexodruck. Es ist aber auch möglich, indirekte Druckverfahren einzusetzen, die dadurch definiert sind, daß das Druckbild zunächst auf einen Zwischenträger angebracht wird. Der Zwischenträger ist flexibel und gibt die Farbe an das Substrat weiter ab. Aus diesem Grund muß das Druckbild bei einem indirekten Druckverfahren seitenrichtig sein. Beispiele für ein indirektes Druckverfahren sind der Offsetdruck und der Tampondruck. Als Tampondruckverfahren wird auch ein Druckverfahren verstanden, bei dem die Tinte mit der Filzspitze eines (tintenlosen) Filzstifts durch Eintauchen der Filzspitze in die Tinte zur Aufnahme der Tinte aufgenommen wird und dann durch Aufdrücken der Filzspitze auf das Substrat zur Abgabe der Tinte abgegeben wird. Ebenso wird als Tampondruckverfahren ein Druckverfahren verstanden, bei dem ein mit Tinte gefüllter Filzstift mit seiner Filzspitze zur Abgabe der Tinte auf das Substrat gedrückt wird und ggf. im aufgedrückten Zustand auf der Oberfläche des Substrats entlang geführt wird. Ebenso kann das Laserdruckverfahren eingesetzt werden, bei dem mittels eines Lasers Teilbereiche einer Walze geladen werden, die Walze an einem entgegengesetzt geladenen Toner vorbeigeführt wird und durch den Ladungsunterschied Partikel des Toners aufnimmt, um dann auf ein Papier aufgebracht zu werden, wenn die Walze nach der Aufnahme der Tonerpartikel an dem Papier vorbeigeführt wird. Ebenso kann ein Wachstinten-Druckverfahren eingesetzt werden, bei dem die Partikel in einem Wachs eingeschlossen sind, das tropfenweise aufgeschmolzen wird, so dass die Tropfen auf eine Walze tropfen und von der Walze auf ein Papier aufgebracht werden. Von den vorbeschriebenen, möglichen Druckverfahren, die nach dem Flach-, Hoch-, Tief- oder Durchdruckverfahren arbeiten, werden insbesondere bevorzugt die Verfahren angewendet, bei denen die Tinte während des Druckvorgangs nicht auf eine Temperatur von über 400°C erhitzt wird.

Unter dem besonders bevorzugt einzusetzenden Tintenstrahldruckerverfahren wird ein Matrixdruckerverfahren verstanden, bei dem durch den gezielten Abschuß oder das Ablenken kleiner Tintentröpfchen ein Druckbild erzeugt wird. Das Druckverfahren kann als Ein- oder Mehrstrahlverfahren durchgeführt werden, wobei beim Mehrstrahlverfahren pro Zeiteinheit mehrere Tröpfchen abgeschossen werden, nämlich in parallelen "Strahlen". In beiden Fällen (Ein- und Mehrstrahler) tritt der Tintenstrahl über eine Düse aus dem Druckkopf aus. Dieser Strahl kann in einer bevorzugten Ausführungsform über einen piezoelektrischen Wandler, der sich hinter der Düse befindet, moduliert werden, so daß ein gleichmäßiger Zerfall (Rayleigh'scher Tropfenzerfall) in einzelne Tropfen erreicht wird. In einer bevorzugten Ausführungsform können über eine Ladeelektrode die so gebildeten Tropfen mehr oder weniger stark elektrostatisch aufgeladen. Die 10 bis 40 m/s schnellen Tropfen durchfliegen anschließend eine größere Ablenkelektrode, wo sie - abhängig von ihrer spezifischen elektrischen Ladung - seitlich abgelenkt werden. Je nach Gerätetyp gelangen nun die geladenen bzw. die ungeladenen Tropfen auf das Substrat. Nicht benötigte Tropfen können bereits am Druckkopf wieder aufgefangen und erneut dem Tintenkreislauf zugeführt werden. Das Tintenstrahldruckverfahren kann als Binary-Deflecting-Verfahren und Multi-Deflecting-Verfahren betrieben werden. Bei Ersterem kommt der Tropfen entweder auf das Substrat oder er wird in einen Tropfenfänger abgelenkt. Beim Multi-Deflecting-Verfahren können die Tropfen durch unterschiedliche Ladungszustände unterschiedlich abgelenkt werden. Auf diese Weise ist es möglich, über eine Düse eine breitere Zeile zu drucken. Die Breite der Zeile ist abhängig vom Abstand der Düse zum Substrat, wodurch ein höherer Abstand die Auflösung vermindert.

Alternativ zur Ausführungsform mit einer Ladeelektrode kann das besonders bevorzugt eingesetzte Tintenstrahldruckverfahren auch ohne Ladeelektrode ausgeführt werden. Die gebildeten Tropfen werden dann mittels eines in dem Druckkopf vorgesehenen Kanals zu dem Papier geführt. Am Ausgang des Kanals treten die gebildeten Tropfen aus und treffen auf das Papier auf.

Der Einsatz des Tintenstrahldruckverfahrens bietet den Vorteil, dass die Bildung und Förderung der Tinte im Druckkopf durch verformungsbasierten Druck erfolgt und somit die Temperatur in dem Druckkopf und damit in der Tinte im wesentlichen der Raumtemperatur entspricht, zumindest aber nicht über 400°C ansteigt. Dadurch kann vermieden werden, dass - falls Nanopartikel in der Tinte vorhanden sind, die einen solchen Phasensprung durchführen - bereits in der Tinte ein Phasensprung von HCP (hexagonal closest packed structure) zu FCC (face centred cubic structure) erfolgt. In einer alternativen Ausführungsform kann ein Druckverfahren eingesetzt werden, bei dem die Temperatur in dem Druckkopf und damit in der Tinte im wesentlichen über 400°C ansteigt. Dadurch kann erreicht werden, dass - falls Nanopartikel in der Tinte vorhanden sind, die einen solchen Phasensprung durchführen - bereits in der Tinte ein Phasensprung von HCP (hexagonal closest packed structure) zu FCC (face centred cubic structure) erfolgt. Ebenso ist es in einer alternativen Ausführungsform möglich, dass bereits vor der Durchführung des Druckprozess Nanopartikel in der Tinte vorhanden sind, die eine FCC aufweisen.

Insbesondere bevorzugt wird ein Druckverfahren eingesetzt, bei dem Tröpfchen erzeugt, bzw. Tonerpartikel verwendet werden, die auf das Substrat aufgebracht werden, wie beim besonders bevorzugten Tintenstrahldruckverfahren beispielsweise Tröpfchen erzeugt werden, die von dem Druckkopf "abgeschossen" werden. Insbesondere bevorzugt werden Druckverfahren eingesetzt, die Tröpfchen erzeugen, bzw. Tonerpartikel eingesetzt, die einen durchschnittlichen Tröpfcheninhalt von weniger als 500 pikoliter, insbesondere bevorzugt von weniger als 100 pikoliter, insbesondere bevorzugt von weniger als 50 pikoliter, ganz besonders bevorzugt von weniger als 10 pikoliter und vorzugsweise von etwa 1.5 pikoliter haben. Je geringer der Tröpfcheninhalt, desto feiner die Auflösung des mit dem Druckverfahren erzeugbaren "Bildes", also der Anordnung der Tinte auf dem Substrat.

In einer bevorzugten Ausführungsform wird das Druckverfahren mit einem Dispenser, bzw. Mikrodispenser, vorzugsweise einem Drucker durchgeführt, der keine magnetischen und/oder keine metallischen Bauteile aufweist. Magnetische oder metallische Bauteile können beispielsweise die Verteilung der Nanopartikel in der Tinte beeinflussen. Insbesondere bevorzugt wird ein Drucker eingesetzt, bei dem zumindest die Bauteile, die in Kontakt mit der Tinte kommen, keine magnetischen oder metallischen Bauteile sind, während Bauteile, die nicht in Kontakt mit der Tinte kommen, magnetisch oder metallisch sein können. Vorzugsweise ist der Drucker EMFabgeschirmt, hat also eine Schirmung gegen Elektromagnetische Felder (EMF).

In einer bevorzugten Ausführungsform wird die Tinte vor dem Aufbringen auf das Substrat durchmischt. Dies kann vorzugsweise zu einer gleichmäßigen Verteilung der Nanopartikel in der Tinte führen. Beispielsweise kann die Tinte in einem Reservoir gespeichert sein und in dem Reservoir durchmischt werden, beispielsweise durch Rütteln des Reservoirs oder durch statische und/oder bewegte Mischelemente, die in das Reservoir eintauchen. Ebenso kann die Tinte beispielsweise beim Entnehmen aus dem Reservoir durchmischt werden, beispielsweise indem zum Entnehmen der Tinte aus einem Reservoir eine Ansaugvorrichtung in die Tinte in dem Reservoir eingetaucht wird und der Eintauchprozeß ruckartig erfolgt. Ebenso kann die Tinte in Leitungen der Druckvorrichtung - falls solche vorhanden sind - durchmischt werden, beispielsweise indem diese Leitungen gerüttelt werden oder indem in den Leitungen statische und/oder bewegte Mischelemente vorgesehen sind, an denen die Tinte vorbei gefördert wird. Ebenso können Ultraschallköpfe vorgesehen sein, die Ultraschallwellen in die Tinte einbringen und die Tinte dadurch durchmischen. Ebenso kann ein Durchmischen dadurch erfolgen, dass durch Ansaugen in eine Pipette eine Teilmenge der Tinte in die Pipette aufgenommen und anschließend wieder ausgestoßen wird. Durch den beim Ausstoßen erzeugten, in die übrige Tinte eindringenden Flüssigkeitsstrahl kann die übrige Tinte durchmischt werden.

In einer bevorzugten Ausführungsform ist ein Tintenreservoir - soweit vorhanden - vor Umgebungseinflüssen, insbesondere vor Sauerstoff geschützt. Dadurch kann vermieden werden, dass metallische Nanopartikel oxidieren. In einer bevorzugten Ausführungsform kann eine Schutzgasvorrichtung für ein Tintenreserviors vorgesehen sein. Diese kann im wesentlichen ein Kasten mit Membranen sein, die vom Druckkopf durchstochen werden können, um so in das Innere des Reserviors zu gelangen und dort Tinte anzusaugen. Der Kasten kann mit Schutzgas, beispielsweise Stickstoff gefüllt sein und kann einen leichten Überdruck zur Umgebung haben, so dass durch die Membran Schutzgas austreten kann, aber kein Sauerstoff in die Schutzgasvorrichtung eindringen kann.

In alternativen Ausführungsformen können folgende Druckverfahren eingesetzt werden: Scher-Jet, Continous-Jet, MEMS-Ventil, Thermische Aktoren (Bubble jet) und Roll-On-roll Druck.

Die auf dem Substrat anzuordnenden Nanopartikel sind aus einem elektrisch leitfähigen Material, Nanopartikeln aus einem magnetischen Material und/oder Nanopartikeln aus einem magnetisierbaren Material. Neben den Nanopartikel aus einem elektrisch leitfähigen Material, den Nanopartikeln aus einem magnetischen Material und/oder Nanopartikeln aus einem magnetisierbaren Material können Nanopartikel auch aus nicht-leitendem Material eingesetzt werden, beispielsweise um zwischen leitenden Nanopartikel eine Isolation einzubringen oder beispielsweise für eine Passivierung. Als Nanopartikel aus einem magnetischen Material werden derartige Nanopartikel verstanden, die bereits ein Magnetfeld erzeugen. Als Nanopartikel aus einem magnetisierbaren Material werden Nanopartikel verstanden, die durch weitere Schritte, beispielsweise Anlegen eines äußeren Magnetfeldes, dazu umgewandelt werden können, selbst ein Magnetfeld zu erzeugen. Es sind auch superparamagnetische Nanopartikel denkbar, die nach außen kein Magnetfeld erzeugen, aber auf ein Magnetfeld reagieren könne, wie zum Beispiel der TMR-Effekt (Tunneling Magneto-Resistive Effekt) am Grenzübergang Magnet/Isolator.

Insbesondere bevorzugt sind die Nanopartikel aus Kobalt (Co), Samarium (Sm), Eisen (Fe), Ruthenium, Neodym oder anderen seltenen Erden oder aus Legierungen, die eines oder mehrerer dieser Elemente enthalten, wie beispielsweise Eisen/Kobalt (FeCo)-Legierungen oder Kobalt/Kupfer (CoCu)-Legierungen

Die in der Tinte enthaltenen Nanopartikel, beziehungsweise mit einer Hülle umgebenen Nanopartikel haben vorzugsweise einen mittleren Durchmesser von weniger als 100 nm (bei einer mit Hülle umgebenen Nanopartikeln bezieht sich diese Angabe auf den Durchmesser des Nanopartikels selbst). Insbesondere bevorzugt haben die Nanopartikel einen mittleren Durchmesser von weniger als 50 nm, besonders bevorzugt von weniger als 20 nm. Insbesondere werden für elektrische Bauteile, die einen ferromagnetischen Effekt aufweisen sollen, Partikel mit einem mittleren Durchmesser von 15 nm eingesetzt und für elektrische Bauteile, die einen superparamagnetischen Effekt aufweisen sollen, Partikel mit einem mittleren Durchmesser von 6 nm eingesetzt.

Die Nanopartikel müssen nicht zwingend kugelförmig sein. Sie können beispielsweise länglich (zigarrenförmig) oder oval oder elliptisch ausgebildet sein. Bei einer "Zigarrenform" der Nanopartikel wird eine anisotrope Ausrichtung der Partikel ermöglicht. In einer bevorzugten Ausführungsform sind die Nanopartikel jedoch im wesentlichen kugelförmig oder oval oder elliptisch.

In einer bevorzugten Ausführungsform weisen die in der Tinte enthaltenen Nanopartikel einen im wesentlichen gleichen Durchmesser auf, wobei in einer bevorzugten Ausführungsform die Standartabweichung (Sigma) der Nanopartikeldurchmesserverteilung kleiner 10 %, insbesondere bevorzugt kleiner 5 % ist. Bei derartigen Nanopartikeldurchmesserverteilungen stellt sich die Selbstorganisation der Nanopartikel besonders gut ein.

In einer bevorzugten Ausführungsform weisen die Nanopartikel eine Oxidhülle auf, die dann wiederum von einer Ligandenhülle umgeben wird. Dadurch werden die Nanopartikel stabil gegen Oxidation, so daß ein Entfernen der Ligandenhülle an der Umgebungsluft möglich ist. In einer bevorzugten Ausführungsform hat die Oxidhülle eine Oxiddicke von 2 nm, insbesondere bevorzugt von 1,5 nm und ganz besonders bevorzugt von 1 nm .

In einer bevorzugten Ausführungsform kann eine Tinte zwei oder mehr unterschiedliche Typen von Nanopartikeln enthalten, beispielsweise als ersten Typ Nanopartikel ohne ein Hülle und als zweiten Typ Nanopartikel mit einer Hülle oder beispielsweise als ersten Typ Nanopartikel eines ersten Materials (beispielsweise aus einem magnetischen Material oder aus einem magnetisierbaren Material) und als zweiten Typ Nanopartikel eines zweiten Materials (beispielsweise aus einem nicht-magnetischen, nicht-magnetisierbaren, elektrisch leitfähigem Material). Eine Tinte mit zwei oder mehr unterschiedlichen Typen von Nanopartikeln kann dazu verwendet werden, in einem einzigen Druckschritt eine Struktur von Nanopartikeln unterschiedlichen Typs auf dem Substrat zu erzeugen. Beispielsweise kann für eine mögliche Art, den GMR-Effekt einzustellen, erst eine Nanopartikel-Ebene mit einer Tinte, die nur einen Typ Nanopartikel enthält, erzeugt werden, wonach die Liganden entfernt und dann eine Leitungsebene mit einer Tinte mit leitfähigen Nanopartikel erzeugt wird. Abschließend wird eine Passivierungsebene mit einer Tinte mit Nanopartikeln, die eine passivierende Wirkung haben, erzeugt. Für eine mögliche Art, den TMR Effekt einzustellen, kann beispielsweise eine Tinte mit einem Gemisch aus Nanopartikeln verwendet werden, beispielsweise superparramagnetische Nanopartikel und Gold-Nanopartikel, beide mit Ligandenhülle. Die Nanopartikel des Gemischs sind bevorzugt so konzipiert, dass sich Molekülbindungen bilden, die eine gewünschte Matrixanordnung superparamagnetischer Nanopartikel zu Gold-Nanopartikeln herstellen. Der TMR-Effekt ensteht an der Grenzschicht superparamagnetischer Nanopartikel-Oxidschicht. Wenn diese definiert eingestellt ist kann der TMR-Effekt genutzt werden. Gold dient zum elektrischen Kontakt untereinander. Das Mischverhältnis kann beispielsweise 1:1 sein.

In einer bevorzugten Ausführungsform weist die bei dem erfindungsgemäßen Herstellungsverfahren eingesetzte Tinte ein Lösungsmittel auf, in dem die Nanopartikel gelöst sind. Gemäß einer bevorzugten Ausführungsform des erfindungsgemäßen Herstellungsverfahrens wird das Lösungsmittel nach dem Aufbringen der Tinte auf das Substrat verdampft. Als Lösungsmittel wird insbesondere bevorzugt 1,2-Dichlorbenzol und als Stabilisator: Trioctylphosphinoxid (TOPO), Ölsäure, Ölamin, und/oder Leinölgemische eingesetzt. Bevorzugt wird eine an Umbebungsluft flüchtige Verbindung, die unter Schutzatmosphäre eine stabilisierende Wirkung auf die Nanopartikel hat, eingesetzt und so eine Agglomeration und Sedimentation dieser verhindern. Es kann zu einem Energieeintrag durch Braunsche Bewegung bei Raumtemperatur kommen.

Das Lösungsmittel der Tinte ist vorzugsweise chemisch stabil gegenüber dem Material der bei einer Ausführungsform der Erfindung vorgesehenen Hülle um die Nanopartikel und insbesondere bevorzugt stabil gegenüber dem Material der Nanopartikel.

Das Lösungsmittel weist insbesondere bevorzugt eine langsame Verdampfungsgeschwindigkeit auf. 1,2-Dichlorbenzol kann innerhalb weniger Minuten verdampfen, wobei die Verdampfungsgeschwindigkeit von der Menge und der relativen Oberfläche (Grenzfläche) zur Umgebungsluft abhängt. Wünschenswert für den Herstellungsprozess ist eine Verdampfung innerhalb von 2 bis 5min(manuelle Handling möglich). Es kann aber auch wünschenswert sein schneller zu verdampfen (maschinelles Handling).

Die Tinte wird vorzugsweise einem Reservoir entnommen, das einen Kontakt der Tinte mit Sauerstoff verhindert. Beispielsweise kann das Reservoir luftdicht verschlossen sein und/oder in einer Schutzgasatmosphäre (beispielsweise Stickstoff) angeordnet sein. Somit kann verhindert werden, daß die Nanopartikel oxidieren. Ebenso können Mischvorrichtungen vorgesehen sein, die die Tinte während der Lagerung im Reservoir mischen.

Es wird eine Tinte eingesetzt, die mit einer Hülle umgebene Nanopartikel enthält. Das Umgeben der Nanopartikel mit einer Hülle erlaubt es, die Nanopartikel zu stabilisieren. Bei den in der Tinte gelösten Nanopartikeln kann die Tendenz bestehen, Agglomerationen oder Coagulate zu bilden. Diesen Prozessen wird in einer bevorzugten Ausführungsform des erfindungsgemäßen Herstellungsverfahrens entgegengewirkt. Als Stabilisationsmöglichkeiten bieten sich die Ladungsstabilisation, die Stabilisation durch Polymere oder die steirische Stabilisierung an. Im Rahmen des erfindungsgemäßen Herstellungsverfahrens wird die steirische Stabilisierung eingesetzt. Die Ladungsstabilisation erfolgt über die elektrostatische Abstoßung gleichnamiger Ladungen. Die Ladungsstabilisation tritt beispielsweise bei Silberhalogenidpartikeln auf. Die Stabilisation durch Polymere, wie beispielsweise PVP (Polyvinylpyridin) kann zu einer räumlichen Trennung der Partikel aufgrund der Größe der Polymermoleküle führen. Bei der steirischen Stabilisierung erfolgt die Trennung der Nanopartikel durch eine Ligandenhülle, die die Partikel voneinander trennt und beispielsweise vor Oxidation schützen kann. Unter Liganden werden amphiphile Moleküle verstanden, die mit ihrer hydrophilen Kopfgruppe kovalente oder koordinative Bindungen mit dem Partikelkern (dem Nanopartikel) ausbilden und deren hydrophobe Alkylketten in die Lösung zeigen. Beim Einsatz von Nanopartikeln mit Ligandenhülle werden bevorzugt unpolare Medien als Lösungsmittel eingesetzt. Die Stärke der Bindung zwischen Kopfgruppe und Kern kann das Wachstum und die Form der Partikel beeinflussen, während die Länge der Alkylkette das Wechselwirkungspontial zwischen den Partikeln mitbestimmt.

In einer bevorzugten Ausführungsform des erfindungsgemäßen Herstellungsverfahrens werden die Nanopartikel zumindest durch die folgenden Verfahrensschritte erzeugt:
- Erzeugung von Keimen durch Reduktion von Metallsalzen oder einer Zersetzung metallorganischer Verbindungen in einem Lösungsmittel,
- Wachstum der Keime und
- Oswald Reifungsprozess.

Insbesondere erfolgt die Erzeugung der Keime der Nanopartikel, beispielsweise der Kobalt-Nanopartikel oder FeCo-Nanopartikel über die Thermolyse metallorganischer Trekusoren in einer binären Tensidlösung, wie es beispielsweise in W.F. Puntes, K.M. Krishnan und P. Alivisatos, Science 291, 2115 (2001) beschrieben wird. Für eine detaillierte Darstellung der Herstellungsmethoden der Nanopartikel verweisen wir auf Kapitel 2.1 der Diplomarbeit, beziehungsweise Kapitel 3.1 und 3.1.1 der Doktorarbeit von Frau Dr. Ennen. Diese Kapitel werden für die Herstellung der Nanopartikel durch Bezugnahme in diese Beschreibung des erfindungsgemäßen Herstellungsverfahrens aufgenommen und stellen somit Teil der Beschreibung des erfindungsgemäßen Herstellungsverfahrens dar.

In einer bevorzugten Ausführungsform erfolgt nach dem Oswald-Reifungsprozess eine Stabilisierung der während des Oswald-Reifungsprozesses erzeugten Nanopartikel, beispielsweise durch Erzeugen der Ligandenhülle.

In einer bevorzugten Ausführungsform besteht das Substrat zumindest teilweise, insbesondere mehrheitlich aus Siliziumoxid. Alternativ oder ergänzend kann das Substrat eine Chipoberfläche, beispielsweise aus prozessiertem Silizium und/oder Germanium sein. Ebenso kann das Substrat zumindest teilweise aus einem Kunststoff oder aus einer Keramik oder aus Glas sein. Das Substrat kann eine Leiterplatte sein, konventioneller Art oder Flexprint. Auf der Leiterplatte können Strukturen integriert sein, die das Aufbringen der Tinte beeinflussen. Das können mechanische Strukturen sein, wie Kanäle, oder spezielle Beschichtungen, auf denen die Nanopartikel binden oder - falls gewüncht - gerade nicht binden. Weitere Strukturen sind elektrische Leiterbahnen, die bei Bestromung elektrische und / oder magnetische Felder erzeugen, die das Ablagerungsverhalten beeinflussen. Das Substrat kann als Folie ausgestaltet sein. Das Substrat kann ein Isolator sein. Das Substrat kann Mittel aufweisen, die ein Magnetfeld erzeugten können, so daß beispielsweise während des Aufbringens der Tinte eine Magnetfeld erzeugt werden kann. Ebenso kann das Substrat eine Platinoberfläche aufweisen oder eine prozessierte Chipoberfläche sein. Das Substrat kann mit einem Plasma vorbehandelt werden, um möglichst viele Nanopartikel an der Oberfläche zu binden.

Mit dem erfindungsgemäßen Herstellungsverfahren werden elektrische Bauteile hergestellt, die mindestens zwei elektrische Kontakte aufweisen. Diese elektrischen Kontakte sind vorzugsweise auf dem gleichen Substrat angeordnet, auf das die Tinte aufgebracht wird. In einer ersten Ausführungsform sind die elektrischen Kontakte bereits auf, beziehungsweise in dem Substrat vorgesehen. Die Tinte kann dann beispielsweise auf die elektrischen Kontakte aufgedruckt, oder zumindest die elektrischen Kontakte zum Teil überlappend aufgebracht werden. Ebenso kann es vorgesehen sein, die Tinte in einem Abstand zu den elektrischen Kontakten auf das Substrat aufzubringen und dann eine elektrische Verbindung zwischen den Kontakten und den Nanopartikeln zu erzeugen, beispielsweise durch Aufdrucken eines elektrisch leitenden Materials beispielsweise durch Aufdrucken einer zweiten Tinte mit Nanopartikel aus einem nicht-magnetischen, elektrisch leitfähigem Material. Die elektrischen Kontakte des elektrischen Bauteils müssen nicht auf, beziehungsweise in dem Substrat vorgesehen sein, auf die die Tinte aufgebracht wird. Beispielsweise können in einer zweiten Ausführungsform die elektrischen Kontakte auch in einem nachgeschalteten Arbeitsgang auf die auf einem Substrat angeordneten Nanopartikel aufgebracht werden. Auch dieses Aufbringen der Kontakte kann beispielsweise mittels eines Druckverfahrens mit einer zweiten Tinte mit Nanopartikel aus einem nicht-magnetischen, elektrisch leitfähigem Material erfolgen.

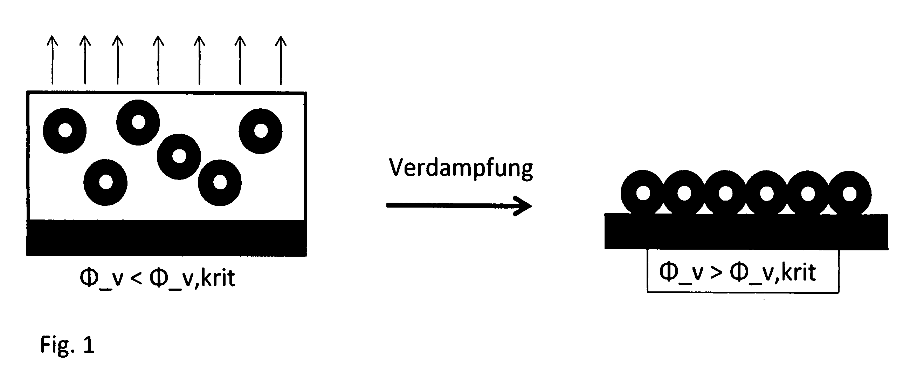

Für das mit dem erfindungsgemäßen Herstellungsverfahren herzustellende elektrische Bauteil ist es von Vorteil, wenn die Nanopartikel innerhalb der Oberflächenbereiche des Substrats, in denen sie auf dem Substrat angeordnet werden sollen, gleichmäßig auf dem Substrat angeordnet sind (gleichmäßige Gitterstruktur). Diese gleichmäßige Gitterstruktur kann man entweder durch Ausnutzung bereits vorhandener Strukturen herstellen (beispielsweise kann das Substrat eine Oberflächenstruktur aufweisen, beispielsweise Senken, so daß nach dem Drucken in jeder Senke ein Nanopartikel angeordnet ist, wobei die gewünschte Gitterstruktur durch die Oberflächenstruktur eingestellt wird) oder aber beispielsweise und insbesondere bevorzugt durch Ausnutzung der Selbstorganisation der Partikel einstellen. Unter Selbstorganisation von Nanopartikeln wird im Sinne dieser Beschreibung der Erfindung der Übergang von einem ungeordneten Zustand der Partikel in der Tinte zu einer periodischen Anordnung auf dem Substrat verstanden, wie in Figur 1 dargestellt. Für eine detailliertere Beschreibung der Selbstorganisation und der diese Selbstorganisation beeinflussenden Größen verweisen wir auf Kapitel 2.2 der Doktorarbeit von Frau Dr. Inga Ennen ("Magnetische Nanopartikel als Bausteine für granulare Systeme: Mikrostruktur, Magnetismus und Transporteigenschaften"), deren Kapitel 2.2 wir hinsichtlich des Einstellens der Selbstorganisation durch Bezugnahme vollständig in diese Anmeldung mit aufnehmen und deren Kapitel 2.2 bezüglich der Selbstorganisation als Bestandteil dieser Erfindungsbeschreibung hinsichtlich des Einstellens der Selbstorganisation gilt.

In einer bevorzugten Ausführungsform ist der Volumenanteil der Partikel in der Lösung größer 49 % so daß das Lösungsmittel und gegebenenfalls des weiteren in der Tinte befindlichen Elemente einen Volumenanteil von weniger als 51 % einnehmen. Es hat sich gezeigt, daß insbesondere ab einem Volumenanteil von 49 % die Selbstorganisation der Partikel auf dem Substrat besonders gut eintritt. Um die Selbstorganisation der Partikel zu unterstützen, ist es vorteilhaft, eine gleichmäßige Benetzung des Substrats mit der Tinte vorzusehen, die Nanopartikelverteilung besonders klein zu halten und eine gegebenenfalls vorgesehene Verdampfung des Lösungsmittels langsam durchzuführen.

In einer bevorzugten Ausführungsform wird während des Aufbringens der Tinte und/oder während des Entfernens der Flüssigkeit der Tinte ein äußeres Magnetfeld angelegt. Dieses äußere Magnetfeld kann die Anordnung der Nanopartikel beeinflussen und damit zu einer gewünschten Anordnung der Nanopartikel auf dem Substrat führen. Beispielsweise kann das Anlegen eines Magnetfelds bei magnetischen Nanopartikeln dazu führen, daß sich die Nanopartikel in eine bestimmte Richtung ausrichten.

Bei dem erfindungsgemäßen Herstellungsverfahrens wird eine Tinte eingesetzt, die zumindest teilweise Nanopartikel aufweist, die mit einer Hülle umgeben sind, und wobei gemäß einer bevorzugten Ausführungsform bei einer derartigen Tinte nach dem Aufbringen auf das Substrat die das Nanopartikel umgebende Hülle entfernt wird. Das Entfernen der Hülle kann beispielsweise mittels Wärme erfolgen. Alternativ kann darauf verzichtet werden, diese Hülle zu entfernen.

In einer bevorzugten Ausführungsform des erfindungsgemäßen Verfahrens wird ein elektrisch leitendes Material aufgebracht, dass zumindest ein Nanopartikel mit einem elektrischen Kontakt verbindet. Das Aufbringen des elektrisch leitenden Materials kann ebenfalls durch Aufdrucken erfolgen. Das elektrisch leitende Material kann gleichzeitig mit dem Aufbringen der Tinte aufgebracht werden, beispielsweise dadurch, daß eine erste Düse eines Druckkopfs eine Tinte mit einem ersten Typ von Nanopartikeln, beispielsweise aus magnetischem oder magnetisierbarem Material und eine zweite Düse des Druckkopfs eine Tinte mit einem zweiten Typ von Nanopartikeln, beispielsweise aus einem nicht-magnetischen, elektrisch leitenden Material aufbringt. Ebenso kann das elektrisch leitende Material in einem dem Aufbringen der Tinte nachfolgenden Verfahrensschritt aufgebracht werden. Das elektrisch leitende Material kann so aufgebracht werden, daß es ein einziges Nanopartikel mit dem elektrischen Kontakt verbindet. Das elektrisch leitende Material kann aber auch derart aufgebracht werden, daß es eine Mehrzahl von Nanopartikeln zum einen miteinander und zum anderen mit dem elektrischen Kontakt verbindet. Das elektrisch leitende Material kann beispielsweise Gold sein oder Silber, Carbon Nanotubes, Kupfer, beispielsweise wenn als Leiterbahn schon Kupfer eingesetzt wird, oder leitfähige Polymere. Das elektrisch leitende Material kann auch in anderer Form aufgebracht werden und muß nicht mittels eines Druckverfahrens aufgebracht werden. Beispielsweise kann das elektrische Material mittels Lötverfahren, über Bonddrähte oder Inonenstrahlimplantierung aufgebracht werden.

In einer bevorzugten Ausführungsform des erfindungsgemäßen Verfahrens wird ein elektrisch leitendes Material aufgebracht, das zumindest ein auf das Substrat aufgebrachtes Nanopartikel mit einem zweiten auf das Substrat aufgebrachten Nanopartikel verbindet. Das elektrische Bauteil kann beispielsweise derart hergestellt sein, daß ein Nanopartikel einen auf oder in dem Substrat befindlichen Kontakt leitend kontaktiert. Durch das Aufbringen eines elektrisch leitenden Materials, das dieses (erste) Nanopartikel mit einem weiteren (zweiten) Nanopartikel verbindet, kann auch das weitere (zweite) Nanopartikel leitend mit dem Kontakt verbunden werden. Das Aufbringen des elektrisch leitenden Materials kann - falls eine Mehrzahl von Nanopartikeln auf das Substrat aufgebracht wurde - in der weise selektive erfolgen, daß nur einige Nanopartikel der Mehrzahl der Nanopartikel miteinander verbunden werden und andere Nanopartikel gar nicht miteinander verbunden werden (sog. Perkolationstherorie). Durch das Aufbringen des leitenden Materials können Leitungsstränge gebildet werden, wobei ein Leitungsstrang eine erste Gruppe von auf dem Substrat aufgebrachten Nanopartikeln leitend miteinander verbindet, während ein zweiter Leitungsstrang eine zweite Gruppe von auf dem Substrat aufgebrachten Nanopartikeln leitend miteinander verbindet, ohne daß das elektrisch leitende Material des ersten Leitungsstrangs das elektrisch leitende Material des zweiten Leitungsstrangs kontaktiert.

In einer bevorzugten Ausführungsform des erfindungsgemäßen Herstellungsverfahrens wird zumindest auf ein Nanopartikel nach dem Aufbringen des Nanopartikels auf das Substrat eine weitere Schicht, beispielsweise eine Schutzschicht aufgebracht. Die weitere Schicht kann als Isolator dienen. Ebenso kann die weitere Schicht als Schutzschicht, beispielsweise als Schutz gegen Oxidieren oder als Schutz gegen mechanische Einwirkung dienen. Die Schutzschicht kann aus Polymeren bestehen, beispielsweise aus PMMA (Polymethylmethacrylat), aus PVC (Polyvinylchlorid) oder aus Polystyrol.

In einer bevorzugten Ausführungsform werden die Nanopartikel während des Druckvorgangs und/oder nach dem Aufbringen auf das Substrat mit Wärme behandelt. Diese Wärmezufuhr kann zum einem zum Entfernen der vorgesehenen Hülle um die Nanopartikel und/oder zum Verdampfen der Flüssigkeit der Tinte dienen. Die Wärmezufuhr kann in einer Ausführungsform der Erfindung aber auch dazu dienen, die magnetischen Eigenschaften der Nanopartikel zu beeinflussen, beispielsweise den Übergang von superparamagnetischen Eigenschaften zu ferromagnetischen Eigenschaften herzustellen. Dies kann beipielsweise durch ein Erhitzen der Partikel auf über 400°C erreicht werden. Die Wärmezufuhr, insbesondere die Wärmezufuhr zur Änderung der magnetischen Eigenschaften der oder einzelner der aufgebrachten Nanopartikel kann beispielsweise mittels eines Lasers erfolgen. Ein Laser hat eine bestimmte Leistung. Über Pulse und die Anzahl der Pulse sowie deren Länge kann gezielt ein bestimmter Energieeintrag erfolgen. Dies kann insbesondere bevorzugt dazu genutzt werden, den Übergang von hcp zu fcc an definierten Stellen zu erreichen. Ebenso können mit breiten Aperturen (also einer Optik, welche den Laserstrahl aufweitet) auch ganze Flächen und nicht nur kleine Punkte umgewandelt werden ohne benachbarte Flächen signifikant zu stören. Eine Wärmezufuhr, die nur dazu dient, die vorgesehene Hülle um die Nanopartikel zu entfernen und/oder die Flüssigkeit der Tinte zu verdampfen, wird besonders bevorzugt bei Temperaturen von weniger als 400°C, beispielsweise in einem Ofen, durchgeführt. Ergänzend oder alternativ können die Nanopartikel in einer bevorzugten Ausführungsform während des Druckvorgangs und/oder nach dem Aufbringen auf das Substrat mit Hochfrequenzeinstrahlung oder Mikrowellen behandelt werden.

In einer bevorzugten Ausführungsform werden nur einige der auf das Substrat aufgebrachten Nanopartikel mit Wärme behandelt. Dies kann dazu dienen, die magnetischen Eigenschaften nur einiger Nanopartikel zu ändern. Beispielsweise kann auf diese Weise ein Bias-Magnet auf dem Substrat erzeugt werden. Die Feldrichtung des Bias-Magnet kann dadurch eingestellt werden, daß während der Wärmebehandlung ein externes Magnetfeld an die zu behandelnden Nanopartikel angelegt wird. Ebenso können währende der Wärmebehandlung vorher eingebettete Leitungen bestromt werden und so ein definiertes Magnetfeld erzeugt werden.

Die Wärmebehandlung (sowohl zum Entfernen der Hülle als auch zum Verändern der magnetischen Eigenschaften der Nanopartikel) kann in besonderer Atmosphäre, beispielsweise unter Schutzgas-Atmosphäre erfolgen. Dadurch kann ein Oxidieren der Nanopartikel während der Wärmebehandlung verhindert werden.

Ein in einer bevorzugten Ausführungsform vorgesehene Wärmeeintrag während des Druckens der Tinte, insbesondere eine Wärmebehandlung der Tinte während sie sich zwischen einem Druckkopf und dem Substrat befindet kann zu einer Phasenwandlung auf dem Weg von der Düse zum Substrat führen.

In einer bevorzugten Ausführungsform des erfindungsgemäßen Herstellungsverfahrens werden mindestens zwei aufeinander folgende Druckschritte durchgeführt. Dabei kann in einem ersten Druckschritt die Nanopartikel und/oder mit einer Hülle umgebene Nanopartikel enthaltende Tinte auf das Substrat aufgebracht werden, die beispielsweise aus einem magnetischen oder magnetisierbaren Material sind, und mit einem zweiten Druckschritt eine Tinte mit Nanopartikeln aus einem nicht-magnetischen, elektrisch leitenden Material. Ebenso kann in einem Druckschritt eine Schutzschicht auf einige oder alle Nanopartikel aufgebracht werden. Ebenso können in mehreren Druckschritten mehrere Schichten von Nanopartikeln aufgebracht werden. Ebenso kann durch einen ersten Druckschritt eine erste Schicht Nanopartikel (beispielsweise aus einem magnetischen oder magnetisierbaren Material), durch einen zweiten Druckschritt eine Zwischenschicht (beispielsweise aus Nanopartikeln eines anderem Materials (beispielsweise Kunststoff), das sich von dem Material der Nanopartikel der ersten Schicht unterscheidet) aufgebracht werden und in einem dritten Druckschritt eine zweite Schicht Nanopartikel (beispielsweise aus einem magnetischen oder magnetisierbaren Material), die beispielsweise den Nanopartikeln der ersten Schicht entsprechen, aufgebracht werden. Die Zwischenschicht kann auch durch einen anderen Aufbringungsprozeß aufgebracht werden.

### Beispiel A:

1. Lage Nanopartikel aus Kobalt (Co), Samarium (Sm), Eisen (Fe) oder aus Legierungen, die eines oder mehrerer dieser Elemente enthalten, wie beispielsweise Eisen/Kobalt (FeCo)-Legierungen oder Kobalt/Kupfer (CoCu)-Legierungen
2. Lage: elektrisch leitende Schicht, die zumindest einige der Nanopartikel der 1. Lage elektrisch leitend miteinander verbindet
3. Lage: Schutzschicht

### Beispiel B:

1. Lage Nanopartikel aus Kobalt (Co), Samarium (Sm), Eisen (Fe) oder aus Legierungen, die eines oder mehrerer dieser Elemente enthalten, wie beispielsweise Eisen/Kobalt (FeCo)-Legierungen oder Kobalt/Kupfer (CoCu)-Legierungen
2. Lage: Schutzschicht

In einer bevorzugten Ausführungsform werden Stacks aus mehreren Stapel gebildet, beispielsweise mehrere Stapel der 1. bis 3. Lage gemäß Beispiel A übereinander.

In einer bevorzugten Ausführungsform wird mit dem erfindungsgemäßen Herstellungsverfahren ein Sensor erzeugt, der sich zum Erfassen eines Magnetfelds, beziehungsweise einer Änderung eines Magnetfelds einen XMR-Effekt (X-MagnetoResistiv-Effekt), beispielsweise den GMR-Effekt (giant magnetoresistance-Effekt) oder den AMR-Effekt (Anisotrope Magnetoresistive Effekt) oder den TMR-Effekt (Tunnel Magneto Resistance-Effekt) zu Nutze macht.

In einer bevorzugten Ausführungsform sind bei einem in dem erfindungsgemäßen Herstellungsverfahren hergestellten Sensor, der sich dem GMR-Effekt zur Nutze macht, auf dem Substrat sowohl magnetische Nanopartikel aus einem magnetischen Material ("magnetische Nanopartikel", wobei als "magnetische Nanopartikel" auch solche verstanden werden, die aus einem magnetisierbaren Material bestehen und nach dem Aufbringen auf das Substrat derart behandelt werden, daß sie selbst ein Magnetfeld erzeugen) vorgesehen, als auch Nanopartikel aus einem elektrisch leitfähigen, nicht magnetischen Material ("leitfähige Nanopartikel"), die sich in den Zwischenräumen zwischen den magnetischen Nanopartikeln befinden. Eine derartige Anordnung von Nanopartikeln auf einem Substrat kann mit dem erfindungsgemäßen Herstellungsverfahren dadurch erzielt werden, daß sowohl magnetische Nanopartikel als auch leitfähige Nanopartikel in einer einzigen Tinte enthalten sind, die mittels eines Druckverfahrens auf das Substrat aufgebracht werden. Durch das Aufdrucken der beiden Partikeltypen enthaltenen Tinte kann eine zufällige Anordnung der magnetischen Nanopartikel und der leitfähigen Nanopartikel auf dem Substrat erfolgen. Es wird jedoch davon ausgegangen, daß bereits diese zufällige Anordnung von magnetischen und leitfähigen Nanopartikeln zumindest einen geringen, aber ausnutzbaren GMR-Effekt aufweist. Beispielsweise kann durch bestimmte Kopplungspunkte an den Ligandenhüllen eine regelmäßige Matrixanordnung eingestellt werden. Alternativ oder ergänzend kann bei dem erfindungsgemäßen Herstellungsverfahren zunächst eine erste Tinte mittels eines Druckverfahrens aufgebracht werden, wobei die erste Tinte magnetische Nanopartikel oder zumindest überwiegend magnetische Nanopartikel und nur geringe Anteile anderer Nanopartikel enthält. Anschließend kann in einem zweiten Druckschritt eine zweite Tinte aufgebracht werden, die leitfähige Nanopartikel oder zumindest überwiegend leitfähige Nanopartikel und nur geringe Anteile anderer Nanopartikel enthält. Durch das separate Aufbringen der magnetischen Nanopartikel und der leitfähigen Nanopartikel in zwei separaten Druckverfahren kann die Anordnung der magnetischen Nanopartikeln relativ zu den leitfähigen Nanopartikeln eingestellt werden.

In einer bevorzugten Ausführungsform werden bei der zuvor beschriebenen Herstellung eines Sensors mit einem GMR-Effekt magnetische Nanopartikel und leitfähige Nanopartikeln eingesetzt, die mit einer Ligandenhülle umgeben sind. Nach dem gleichzeitigen (eine Tinte) oder sequentiellen (zwei Tinten) Aufbringen der magnetischen Nanopartikel und leitfähigen Nanopartikel kann in einer Fortbildung dieser Ausführungsform in einem weiteren, aber auch in mehreren, teilweise zwischengeschalteten Arbeitsgängen die Ligandenhülle entfernt werden, beispielsweise durch Wärmeeinwirkung. Ebenso kann vor dem Entfernen der Ligandenhülle oder gleichzeitig mit dem Entfernen der Ligandenhülle das Lösungsmittel der Tinte verdampft werden.

Nach dem Aufbringen der magnetischen Nanopartikel und leitfähigen Nanopartikel und dem Entfernen der Ligandenhülle können die magnetischen Nanopartikel und die leitfähigen Nanopartikel auf dem Substrat stabilisiert und geschützt werden. Dies erfolgt in einer bevorzugten Ausführungsform durch Aufbringen einer Polymerschicht, die beispielsweise ebenfalls aufgedruckt werden kann. In einer bevorzugten Ausführungsform wird dabei ein Polymer verwendet, dessen Lösungsmittel die Nanopartikel nicht ablöst.

In einer bevorzugten Ausführungsform werden alle Verfahrensschritte zur Herstellung eines Sensors, der den GMR-Effekt ausnützt, bei Temperaturen von weniger als 400 Grad Celsius durchgeführt. Dadurch wird verhindert, daß die magnetischen Nanopartikel von der HCP-Phase in die FCC-Phase übergehen.

In einer alternativen Ausführungsform wird mit dem erfindungsgemäßen Herstellungsverfahren ein Sensor hergestellt, der den TMR-Effekt einsetzt. Bei diesem Herstellungsverfahren werden insbesondere bevorzugt magnetische Nanopartikel eingesetzt, die eine isolierende, dünne Zwischenschicht aufweisen. Beispielsweise wird die Zwischenschicht durch gezielte Oxidation am Rand des Nanopartikels erzeugt. Das Nanopartikel kann dann über ein leitfähiges Nanopartikel, bspw. ein Goldnanopartikel mit den Kontakten kontaktiert werden.

In einer bevorzugten Ausführungsform des Herstellungsverfahrens zum Herstellen eines Sensors mit TMR-Effekt werden Nanopartikel eingesetzt, die mit einer Ligandenhülle umgeben sind. Durch die Dicke der Ligandenhülle kann der Partikelabstand auf dem Substrat eingestellt werden. Durch dickere Ligandenhüllen weisen die auf das Substrat aufgebrachten Nanopartikeln nach der Selbstorganisation einen größeren Abstand zueinander auf.

In einer bevorzugten Ausführungsform wird nach der Aufbringung der Nanopartikel die Ligandenhülle entfernt, insbesondere bevorzugt durch Wärmeeinwirkung. Nach dem Entfernen der Ligandenhülle bleibt der Partikelabstand zwischen den auf das Substrat aufgebrachte Nanopartikel bevorzugt erhalten. In einer bevorzugten Ausführungsform erfolgt das Entfernen der Ligandenhülle bei den zuvor beschriebenen Ausführungsbeispielen durch Wärmeeintrag mittels eines Lasers. Ebenso kann die Entfernung der Ligandenhülle durch Wärmeeintrag in einem Ofen erfolgen. Ergänzend oder alternativ kann die Ligandenhülle durch Mikrowelleneinstrahlung oder bspw. UV-Lichteinstrahlung entfernt werden.

In einer bevorzugten Ausführungsform wird auf die aufgebrachten Partikel ein Oxidschutz aufgebracht, beispielsweise durch Aufdrucken. In einer bevorzugten Ausführungsform ist der Oxidschutz ein Kunststoff. Insbesondere bevorzugt wird als Oxidschutz ein druckbares Polymer, eine organische Substanz und insbesondere bevorzugt PMMA, Polystyrol oder PVC verwendet. In einer bevorzugten Ausführungsform wird als Oxidschutz ein Kunststoff mit einem Lösungsmittel verwendet, was chemisch stabil gegenüber den magnetischen und leitfähigen Nanopartikeln ist. In einer bevorzugten Ausführungsform härtet ein druckbarer Oxidschutz bei Temperaturen von weniger als 400 Grad Celsius aus.

Das erfindungsgemäße elektrische Bauteil weist mindestens zwei elektrische Kontakten auf und auf einem Substrat angeordnete Nanopartikeln aus einem elektrisch leitfähigen Material, Nanopartikeln aus einem magnetischen Material und/oder Nanopartikeln aus einem magnetisierbaren Material. Die Nanopartikel sind in einem oder mehreren Oberflächenbereichen des Substrats auf dem Substrat angeordnet und sind innerhalb der Oberflächenbereiche in einer regelmäßigen Form mit einer Gitterstruktur auf dem Substrat angeordnet, wobei sich die bereichsweise Gitterstruktur der Nanopartikel über den gesamten jeweiligen Oberflächenbereich erstreckt. Der gesamte jeweilige Oberflächenbereich kann geometrisch in gleichförmige quadratische, aneinandergrenzende Teilbereiche (quadratische Pixel) oder geometrisch im wesentlichen durch gleichförmige kreisrunde oder ellipsenförmige, in einer Matrix nebeneinander angeordnete Teilbereiche (runde Pixel) aufgeteilt werden. Jeder quadratische Teilbereich weist eine Kantenlänge von weniger als 4 Millimeter, insbesondere bevorzugt von weniger als 1 Millimeter und ganz besonders bevorzugt von weniger als 100 Mikrometern auf, bzw. jeder kreisrunde oder ellipsenförmige Teilbereich weist einen maximalen Durchmesser von weniger als 4 Millimeter, insbesondere bevorzugt von weniger als 1 Millimeter und ganz besonders bevorzugt von weniger als 100 Mikrometern auf.

Die geometrische Form der Oberflächenbereiche ergibt sich dadurch, daß die Nanopartikel durch Aufdrucken einer die Nanopartikel und/oder mit einer Hülle umgebene Nanopartikel enthaltende Tinte erzeugt wurden. Derartig erzeugt Oberflächenbereiche setzen sich aus Pixeln (geometrischen Teilbereichen) zusammen.

Der Einsatz von quadratischen Teilbereich mit einer Kantenlänge von weniger als 4 Millimeter, insbesondere bevorzugt von weniger als 1 Millimeter und ganz besonders bevorzugt von weniger als 100 Mikrometern, bzw. von kreisrunden oder ellipsenförmigen Teilbereich mit einem maximalen Durchmesser von weniger als 4 Millimeter, insbesondere bevorzugt von weniger als 1 Millimeter und ganz besonders bevorzugt von weniger als 100 Mikrometern ermöglicht es, Oberflächenbereiche zu erzeugen, die geringe Abmessungen aufweisen und/oder komplexe Formen aufweisen. Dadurch können elektrische Bauteile in einer Vielzahl von Formen und Größen erzeugt werden, wodurch wiederum die Einsatzgebiete des Bauteils vielfältig werden.

Insbesondere bevorzugt weist mindestens ein Oberflächenbereich eine geometrische Form auf, bei der zumindest ein quadratischer Teilbereich, bzw. nur ein kreisrunder oder ellipsenförmiger Teilbereich nur einem weiteren oder nur zwei weiteren quadratischen Teilbereichen, bzw. kreisrunden oder ellipsenförmigen Teilbereich benachbart angeordnet ist. In einer bevorzugten Ausführungsform weist zumindest ein Oberflächenbereich mindestens zwei Reihen quadratischer, bzw. kreisrunder oder ellipsenförmiger Teilbereiche auf, wobei die Anzahl der Teilbereiche in der einen Reihe unterschiedlich von der Anzahl der Teilbereich in der zweiten Reihe ist.

In einer bevorzugten Ausführungsform weist die Gitterstruktur der Nanopartikel eine Monolage Nanopartikel auf, die sich in einer horizontalen Ebene erstreckt. Dadurch kann ein besonders dünnes elektrisches Bauteil erzeugt werden.

In einer bevorzugten Ausführungsform weist die Gitterstruktur der Nanopartikel mehrere übereinander angeordnete horizontale Ebenen auf. Dadurch können elektrische Bauteile mit besonderen Effekten, wie beispielsweise dem GMR-Effekt erzielt werden (obwohl der GMR-Effekt auch mit einer Monolage realisierbar wäre). Ebenso können durch mehrere Lagen die Stärke der durch die Nanopartikel hervorgerufenen Effekte erhöht werden.

In einer bevorzugten Ausführungsform kann zumindest ein Nanopartikel durch eine Schutzschicht bedeckt sein.

In einer bevorzugten Ausführungsform wird das erfindungsgemäße elektrische Bauteil durch das erfindungsgemäße Herstellungsverfahren hergestellt.

In einer bevorzugten Ausführungsform zeigt das elektrische Bauteil einen XMR-Effekt (X-MagnetoResistiv-Effekt), beispielsweise den GMR-Effekt (giant magnetoresistance-Effekt) oder den AMR-Effekt (Anisotrope Magnetoresistive Effekt) oder den TMR-Effekt (Tunnel Magneto Resistance-Effekt).

Nachfolgend wird die Erfindung anhand von lediglich Ausführungsbeispiele darstellenden Zeichnungen näher erläutert. Darin zeigen:
- Fig. 1: eine Skizze des Unordnungs-Ordnungsübergangs bei der Verdampfung des Lösungsmittels einer die mit einer Hülle umgebene Nanopartikel enthaltenden Nanopartikelsuspension.
- Fig. 2: eine Skizze eines mit dem erfindungsgemäßen Herstellungsverfahren hergestellten elektrischen Bauteils in einer ersten Bauform in einer teilweise geschnittenen Seitenansicht,
- Fig. 3: eine Skizze eines mit dem erfindungsgemäßen Herstellungsverfahren hergestellten elektrischen Bauteils in einer zweiten Bauform in einer teilweise geschnittenen Seitenansicht,
- Fig. 4: eine Skizze eines mit dem erfindungsgemäßen Herstellungsverfahren hergestellten elektrischen Bauteils in einer dritten Bauform in einer teilweise geschnittenen Seitenansicht,
- Fig. 5: eine Skizze eines mit dem erfindungsgemäßen Herstellungsverfahren hergestellten elektrischen Bauteils in einer vierten Bauform in einer teilweise geschnittenen Seitenansicht,
- Fig. 6: eine Skizze eines mit dem erfindungsgemäßen Herstellungsverfahren hergestellten elektrischen Bauteil in Form eines Printed Circuit Board in einer perspektivischen Draufsicht,
- Fig. 7: eine Skizze eines mit dem erfindungsgemäßen Herstellungsverfahren hergestellten elektrischen Bauteil in Form eines ASIC (Anwendungsspezifische Integrierte Schaltung) in einer perspektivischen Draufsicht,
- Fig. 8: eine Skizze eines mit dem erfindungsgemäßen Herstellungsverfahren hergestellten elektrischen Bauteil mit einer Folie als Substrat in einer perspektivischen Draufsicht,
- Fig. 9: eine Skizze eines mit dem erfindungsgemäßen Herstellungsverfahren hergestellten elektrischen Bauteil mit einem Bias-Magneten als Substrat in einer perspektivischen Draufsicht,
- Fig. 10: eine Skizze eines mit dem erfindungsgemäßen Herstellungsverfahren hergestellten elektrischen Bauteil mit einem auf das Substrat aufgedruckten Bias-Magneten in einer Draufsicht und
- Fig. 11: eine Skizze eines mit dem erfindungsgemäßen Herstellungsverfahren hergestellten elektrischen Bauteil, das in ein Mikrofluid-System integriert ist in einer Draufsicht.

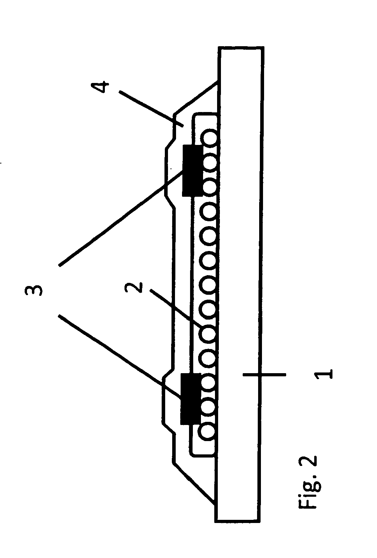

Die in Fig. 1 dargestellte Skizze ist der Doktorarbeit von Frau Dr. Inga Ennen entnommen (Seite 10; Abbildung 2.5). In dem linken Bild der Skizze ist eine auf einen Träger aufgebrachte Nanopartikelsuspension dargestellt. Die Nanopartikel sind mit einer Ligandenhülle umgeben. Im rechten Bild der Skizze ist dargestellt, wie die Nanopartikel nach Verdampfen des Lösungsmittels der Nanopartikelsuspension geordnet auf dem Träger angeordnet sind. Dieser Ordnungsprozess beginnt, wenn der Volumenanteil der Partikel den Wert Φkrit = 0,49 übersteigt.

Die in der Skizze dargestellte Nanopartikelsuspension, die gemäß der Doktorarbeit von Frau Dr. Inga Ennen durch Aufschleudern oder Dippen aufgebracht wird, wird bei dem erfindungsgemäßen Herstellungsverfahren als eine die Nanopartikel und/oder mit einer Hülle umgebene Nanopartikel enthaltende Tinte mittels eines Druckverfahrens auf ein Substrat aufgebracht.

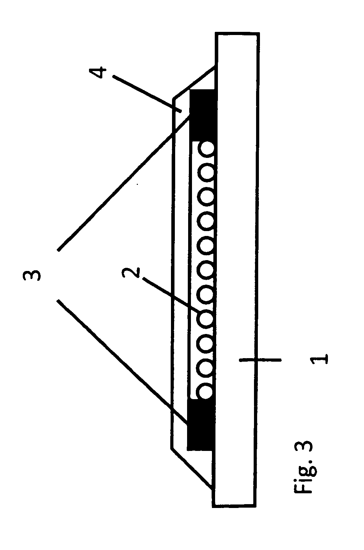

In Fig. 2 und 3 werden Ausführungsformen von mit dem erfindungsgemäßen Herstellungsverfahren hergestellten elektrischen Bauteilen dargestellt. Das elektrische Bauteil weist ein Substrat 1 auf, auf das mittels des erfindungsgemäßen Herstellungsverfahrens eine einlagige Schicht von Nanopartikeln 2 aufgebracht wurde. Die Nanopartikel 2 können aus einem elektrisch leitfähigen Material, aus einem magnetischen Material und/oder aus einem magnetisierbaren Material sein. In der Fig. 2 ist eine elektrische Kontaktierung 3 mit zwei elektrischen Kontakten dargestellt, die oben auf die Schicht von Nanopartikeln 2 aufgebracht wurde. In der Fig. 3 ist die elektrische Kontaktierung 3 mit zwei elektrischen Kontakten neben der Schicht von Nanopartikeln 2 aufgebracht. In Fig. 2 und 3 ist eine Schutzschicht 4 dargestellt, die über die Nanopartikel 2 und die Kontaktierung 3 aufgebracht wurde.

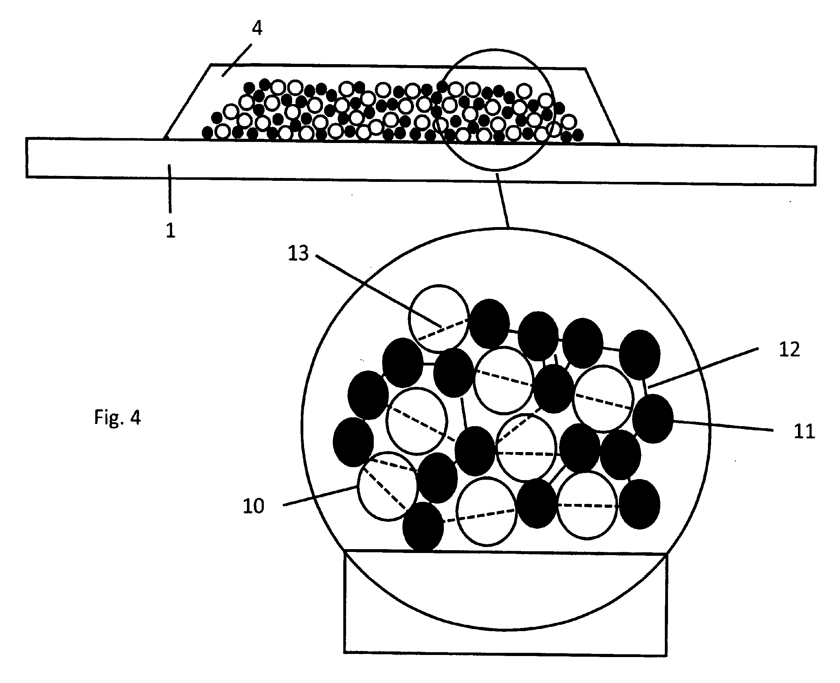

Bei der in Fig. 4 dargestellten Ausführungsform weist das elektrische Bauteil ein Substrat 1 auf, auf das mittels des erfindungsgemäßen Herstellungsverfahrens eine granulares Geflecht von Nanopartikeln 10, 11 aufgebracht wurde. Die Nanopartikel 10 sind magnetische Nanopartikel, die aus magnetischen Material bestehen. Die Nanopartikel 11 sind aus einem elektrisch leitfähigem Material. Zu erkennen ist, dass die Nanopartikel 11 einen direkten Leitungspfad 12 bilden, da einzelne elektrisch leitfähige Materialen sich berühren. Ferner ist ein XMR-sensitiver Leitungspfad 13 durch die magnetischen Nanopartikel 10 zu erkennen. Das in Fig. 4 dargestellte elektrische Bauteil weist eine Schutzschicht 4 auf. Es sind (nicht dargestellte) Kontakte vorgesehen, die jeweils zumindest mit einem elektrisch leitfähigen Nanopartikel 11 kontaktieren.

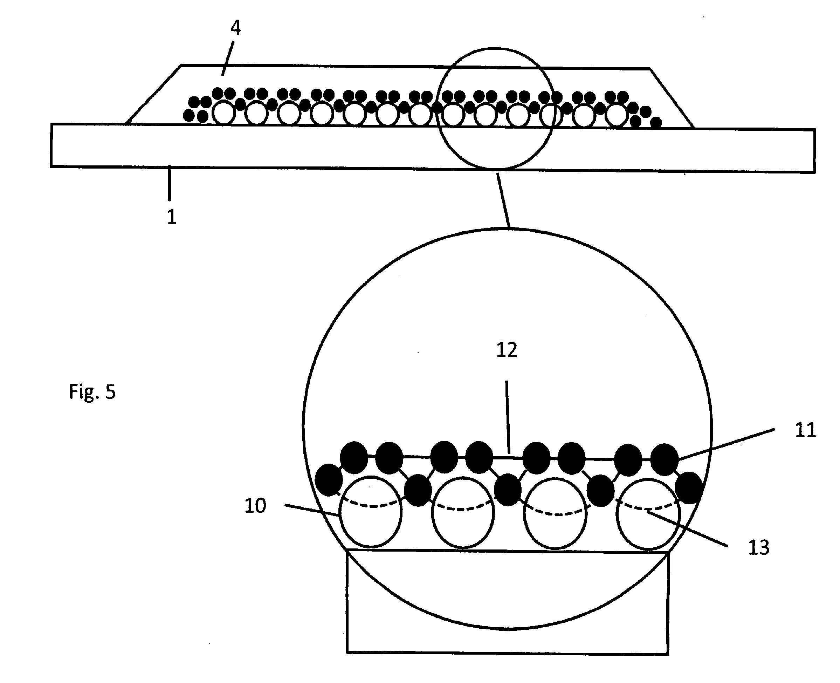

Bei der in Fig. 5 dargestellten Ausführungsform weist das elektrische Bauteil ein Substrat 1 auf, auf das mittels des erfindungsgemäßen Herstellungsverfahrens eine zweilagige Schicht von Nanopartikeln 10, 11 aufgebracht wurde. Die Nanopartikel 10 sind magnetische Nanopartikel, die aus magnetischen Material bestehen. Die Nanopartikel 11 sind aus einem elektrisch leitfähigem Material. Zu erkennen ist, dass die Nanopartikel 11 einen direkten Leitungspfad 12 bilden, da einzelne elektrisch leitfähige Materialen sich berühren. Ferner ist ein XMR-sensitiver Leitungspfad 13 durch die magnetischen Nanopartikel 10 zu erkennen. Das in Fig. 5 dargestellte elektrische Bauteil weist eine Schutzschicht 4 auf. Es sind (nicht dargestellte) Kontakte vorgesehen, die jeweils zumindest mit einem elektrisch leitfähigen Nanopartikel 11 kontaktieren.

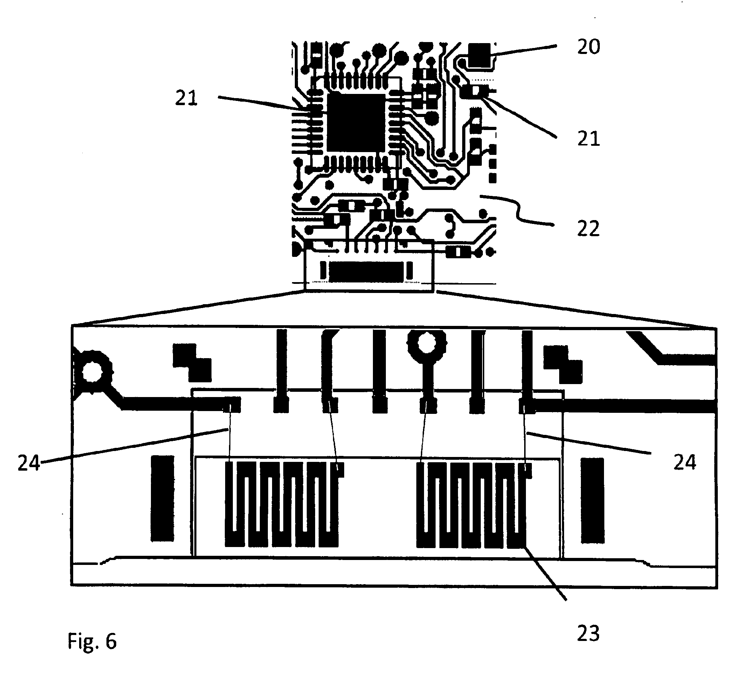

Fig. 6 zeigt, dass das mit dem erfindungsgemäßen Herstellungsverfahren hergestellte elektrische Bauteil auch als Printed Circuit Board (PCB; Leiterplatte) ausgeführt werden kann. Die Leiterplatte 20 bildet zum einen einen Träger für Bauteile 21, die über elektrische Leitungen, beispielsweise an der Trägerplatte (Substrat) 22 haftenden, leitenden Verbindungen (Leiterbahnen) miteinander verbunden sind. Zum anderen sind auf das Substrat 22 der Leiterplatte 20 zudem Nanopartikel unmittelbar aufgedruckt, die die in der Vergrößerung der Fig. 6 dargestellten mäandernden Strukturen 23 bilden. An den Enden der mäandernden Strukturen sind Kontakte 24 vorgesehen, mit denen die durch die aufgedruckten Nanopartikel gebildete Struktur 23 mit den weiteren Bauteilen 21 der Leiterplatte 20 verbunden wird. Die mäandernde Struktur 23 ist so ausgeführt und die Nanopartikel so gewählt, dass das Bauteil einen XMR-Effekt (X-MagnetoResistiv-Effekt), beispielsweise den GMR-Effekt (giant magnetoresistance-Effekt) oder den AMR-Effekt (Anisotrope Magnetoresistive Effekt) oder den TMR-Effekt (Tunnel Magneto Resistance-Effekt) zeigt.

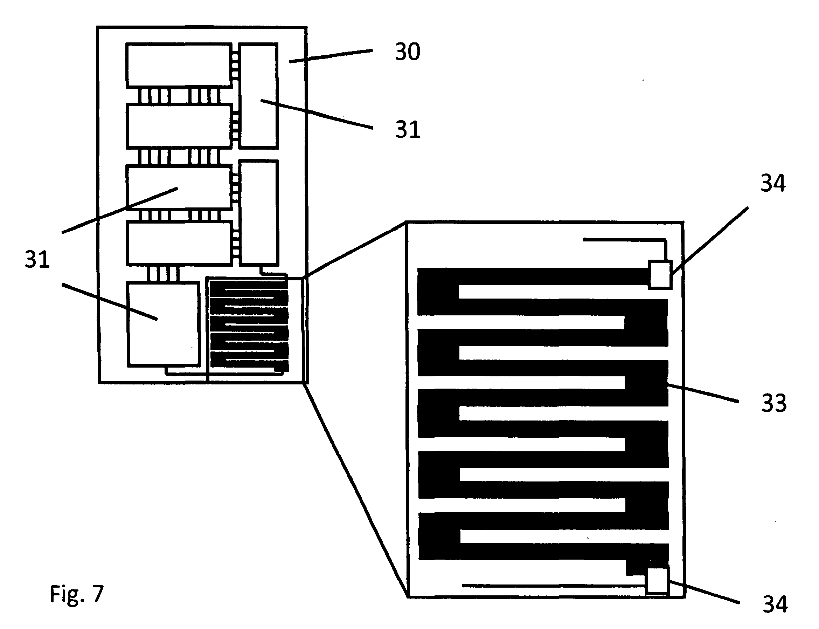

Fig. 7 zeigt, dass das mit dem erfindungsgemäßen Herstellungsverfahren hergestellte elektrische Bauteil auch als eines ASIC (Anwendungsspezifische Integrierte Schaltung) ausgeführt werden kann. Ein Substrat 30 bildet zum einen einen Träger für Bauteile 31, die über elektrische Leitungen, beispielsweise an der Trägerplatte (Substrat) 22 haftenden, leitenden Verbindungen (Leiterbahnen) miteinander verbunden sind. Zum anderen sind auf das Substrat 30 zudem Nanopartikel unmittelbar aufgedruckt, die die in der Vergrößerung der Fig. 7 dargestellten mäandernden Strukturen 33 bilden. An den Enden der mäandernden Strukturen 33 sind Kontakte 34 vorgesehen, mit denen die durch die aufgedruckten Nanopartikel gebildete Struktur 33 mit den weiteren Bauteilen 31 verbunden wird. Die mäandernde Struktur 33 ist so ausgeführt und die Nanopartikel so gewählt, dass das Bauteil einen XMR-Effekt (X-MagnetoResistiv-Effekt), beispielsweise den GMR-Effekt (giant magnetoresistance-Effekt) oder den AMR-Effekt (Anisotrope Magnetoresistive Effekt) oder den TMR-Effekt (Tunnel Magneto Resistance-Effekt) zeigt.

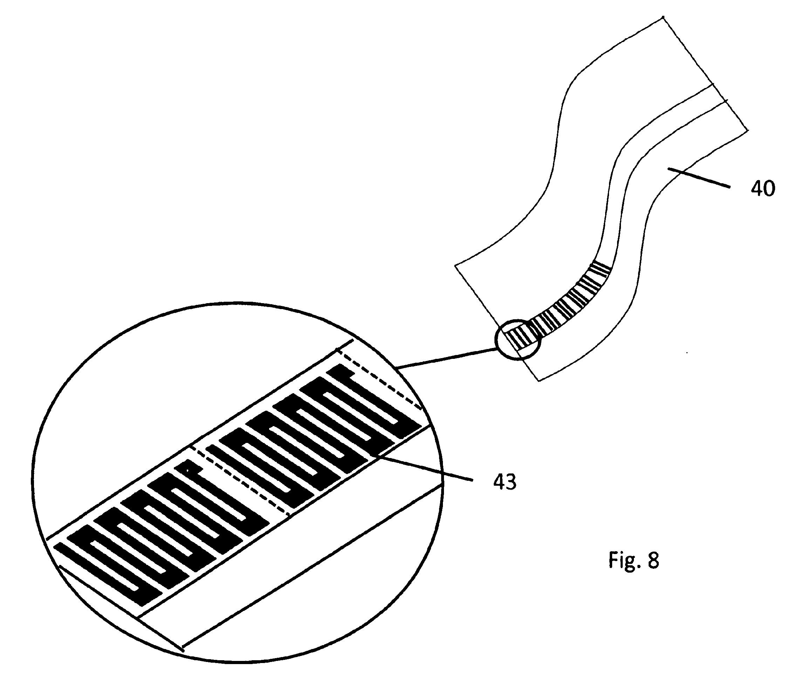

Fig. 8 zeigt, dass das mit dem erfindungsgemäßen Herstellungsverfahren hergestellte elektrische Bauteil auch eine Folie 40 als Substrat aufweisen kann. Auf das Substrat 40 sind Nanopartikel unmittelbar aufgedruckt, die die in der Vergrößerung der Fig. 8 dargestellten mäandernden Strukturen 43 bilden. Die mäandernde Struktur 43 ist so ausgeführt und die Nanopartikel so gewählt, dass das Bauteil einen XMR-Effekt (X-MagnetoResistiv-Effekt), beispielsweise den GMR-Effekt (giant magnetoresistance-Effekt) oder den AMR-Effekt (Anisotrope Magnetoresistive Effekt) oder den TMR-Effekt (Tunnel Magneto Resistance-Effekt) zeigt. In der Fig. 8 strickpunktiert sind Trennlinien dargestellt, an denen die Folie 40 durchtrennt werden kann, um auf diese Weise einzelne Sensoren (elektrische Bauteile) herzustellen.

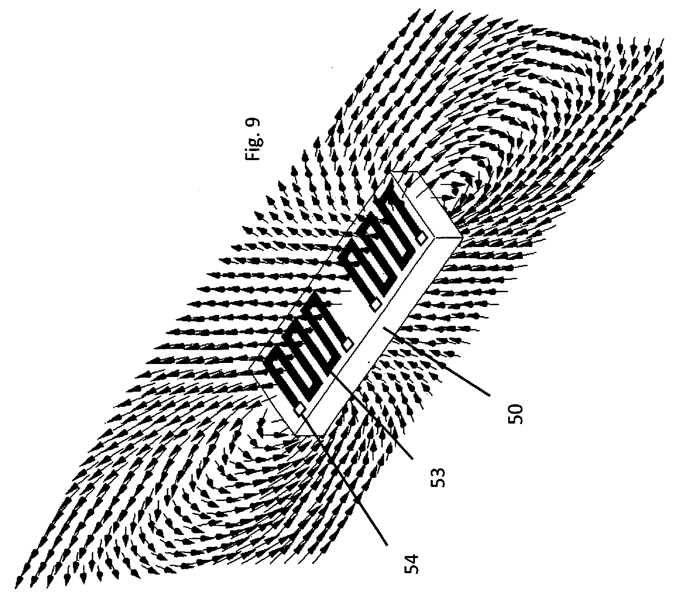

Fig. 9 zeigt, dass das mit dem erfindungsgemäßen Herstellungsverfahren hergestellte elektrische Bauteil auch einen Bias-Magneten 50 als Substrat aufweisen kann. Auf das Substrat 50 sind Nanopartikel unmittelbar aufgedruckt, die die dargestellte mäandernden Strukturen 53 bilden. Die mäandernde Struktur 53 ist so ausgeführt und die Nanopartikel so gewählt, dass das Bauteil einen XMR-Effekt (X-MagnetoResistiv-Effekt), beispielsweise den GMR-Effekt (giant magnetoresistance-Effekt) oder den AMR-Effekt (Anisotrope Magnetoresistive Effekt) oder den TMR-Effekt (Tunnel Magneto Resistance-Effekt) zeigt. An den Enden der mäandernden Strukturen 53 sind Kontakte 54 vorgesehen.

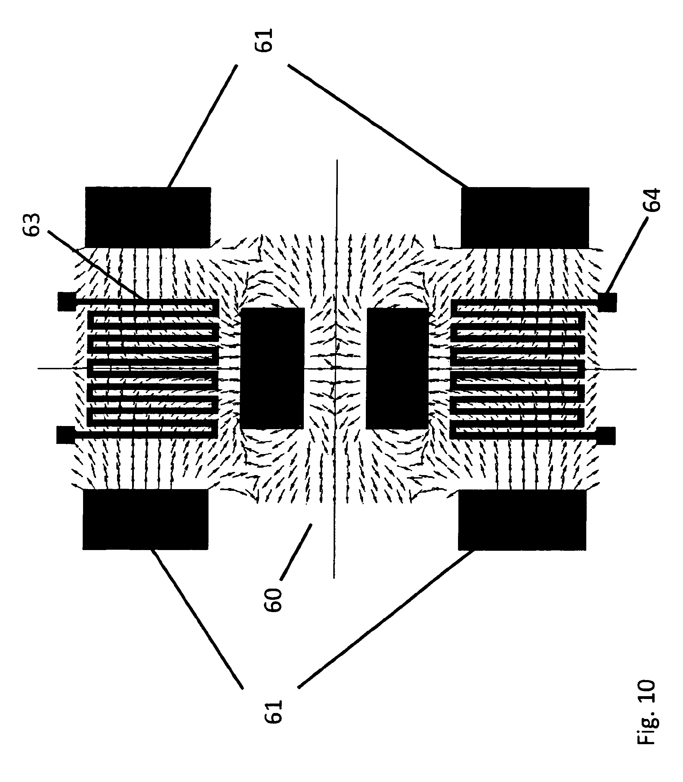

Fig. 10 zeigt, dass das mit dem erfindungsgemäßen Herstellungsverfahren hergestellte elektrische Bauteil auch mit auf das Substrat 60 aufgedruckten Bias-Magneten 61 ausgeführt werden kann. Auf das Substrat 60 sind Nanopartikel unmittelbar aufgedruckt, die die dargestellte mäandernden Strukturen 63 bilden. Die mäandernde Struktur 63 ist so ausgeführt und die Nanopartikel so gewählt, dass das Bauteil einen XMR-Effekt (X-MagnetoResistiv-Effekt), beispielsweise den GMR-Effekt (giant magnetoresistance-Effekt) oder den AMR-Effekt (Anisotrope Magnetoresistive Effekt) oder den TMR-Effekt (Tunnel Magneto Resistance-Effekt) zeigt. An den Enden der mäandernden Strukturen 63 sind Kontakte 64 vorgesehen.

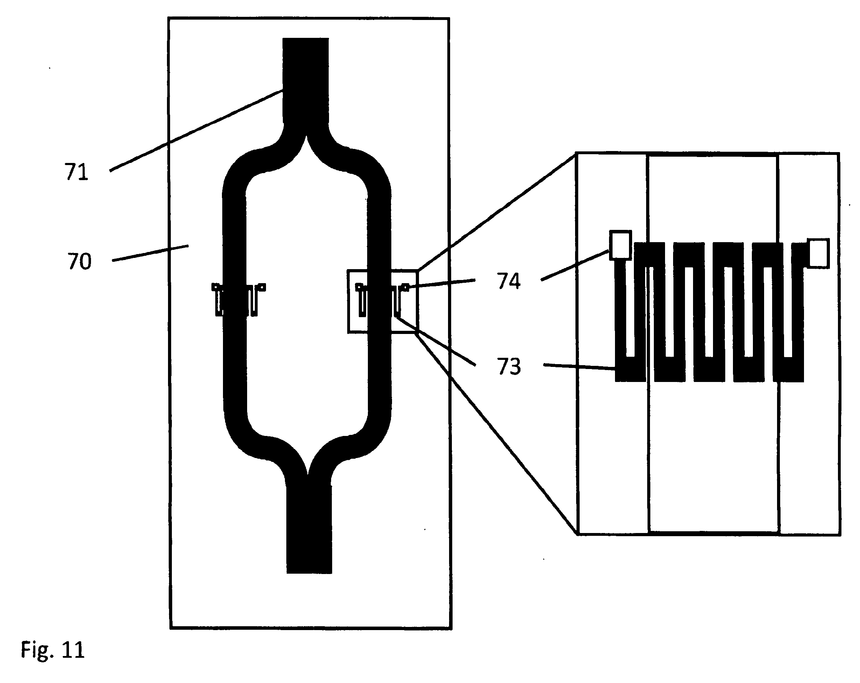

Fig. 11 zeigt, ein Mikrofluid-System. Auf einem Substrat 70 sind Kanäle 71 ausgebildet, durch die eine Flüssigkeit durchtreten kann. Auf das Substrat 70 sind Nanopartikel unmittelbar aufgedruckt, die die dargestellte mäandernden Strukturen 73 bilden. Die mäandernde Struktur 73 ist so ausgeführt und die Nanopartikel so gewählt, dass das Bauteil einen XMR-Effekt (X-MagnetoResistiv-Effekt), beispielsweise den GMR-Effekt (giant magnetoresistance-Effekt) oder den AMR-Effekt (Anisotrope Magnetoresistive Effekt) oder den TMR-Effekt (Tunnel Magneto Resistance-Effekt) zeigt. An den Enden der mäandernden Strukturen 73 sind Kontakte 74 vorgesehen.

## Patentansprüche

1. Verfahren zur Herstellung eines elektrischen Bauteils mit mindestens zwei elektrischen Kontakten (3, 24, 34, 54, 64, 74) und auf einem Substrat (1, 22, 30, 40, 50, 60, 70) angeordneten Nanopartikeln (2, 10, 11) aus einem elektrisch leitfähigen Material, Nanopartikeln (2, 10, 11) aus einem magnetischen Material und/oder Nanopartikeln (2, 10, 11) aus einem magnetisierbaren Material, bei dem eine mit einer Hülle umgebene Nanopartikel (2, 10, 11) enthaltende Tinte mittels eines Druckverfahrens auf das Substrat (1, 22, 30, 40, 50, 60, 70) aufgebracht wird,
**dadurch gekennzeichnet,**
**dass** die mit einer Hülle umgebenen Nanopartikel mit einer Ligandenhülle umgeben sind.

2. Herstellungsverfahren nach Anspruch 1, **dadurch gekennzeichnet, daß** die in der Tinte enthaltenen Nanopartikel (2, 10, 11) im wesentlichen kugelförmig sind.

3. Herstellungsverfahren nach Anspruch 1 oder 2, **dadurch gekennzeichnet, daß** die in der Tinte enthaltenen Nanopartikel (2, 10, 11) einen im wesentlichen gleichen Durchmesser aufweisen und die Standardabweichung (SIGMA) der Nanopartikeldurchmesserverteilung kleiner 10%, insbesondere bevorzugt kleiner 5% ist.

4. Herstellungsverfahren nach einem der Ansprüche 1 bis 3, **dadurch gekennzeichnet, daß** die Nanopartikel (2, 10, 11) durch folgende Verfahrensschritte erzeugt wurden:
- Erzeugung von Keimen durch Reduktion von Metallsalzen oder eine Zersetzung metallorganischer Verbindungen in einem Lösungsmittel,
- Wachstum der Keime und
- Ostwald-Reifungsprozeß.

5. Herstellungsverfahren nach Anspruch 5, **dadurch gekennzeichnet, daß** nach dem Ostwald-Reifungsprozeß eine Stabilisierung der während des Ostwald-Reifungsprozeß durchgeführt wird.

6. Herstellungsverfahren nach einem der Ansprüche 1 bis 5, **dadurch gekennzeichnet, daß** die Tinte ein Lösungsmittel aufweist, in dem die Nanopartikel (2, 10, 11) gelöst sind, und daß das Lösungsmittel nach dem Aufbringen der Tinte auf das Substrat (1, 22, 30, 40, 50, 60, 70) verdampft wird.

7. Herstellungsverfahren nach einem der Ansprüche 1 bis 6, **dadurch gekennzeichnet, daß** die Nanopartikel (2, 10, 11) in der Tinte einen Volumenanteil von mehr als 49 % des Gesamtvolumens der Tinte einnehmen.

8. Herstellungsverfahren nach einem der Ansprüche 1 bis 7, **dadurch gekennzeichnet, daß** ein elektrisch leitendes Material aufgebracht wird, daß zumindest ein Nanopartikel (2, 10, 11) mit einem elektrischen Kontakt verbindet.

9. Herstellungsverfahren nach einem der Ansprüche 1 bis 8, **dadurch gekennzeichnet, daß** zumindest ein in der Tinte enthaltenes Nanopartikel (2, 10, 11) eine Hülle aufweist und die Hülle nach dem Aufbringen der Tinte auf das Substrat (1, 22, 30, 40, 50, 60, 70) entfernt wird.

10. Herstellungsverfahren nach einem der Ansprüche 1 bis 9, **dadurch gekennzeichnet, daß** zumindest auf ein Nanopartikel (2, 10, 11) nach dem Aufbringen des Nanopartikels (2, 10, 11) auf das Substrat (1, 22, 30, 40, 50, 60, 70) eine Schutzschicht (4) aufgebracht wird.

11. Herstellungsverfahren nach einem der Ansprüche 1 bis 10, **dadurch gekennzeichnet, dass** ein Sensor erzeugt wird, der einen XMR-Effekt (X-MagnetoResistiv-Effekt), beispielsweise den GMR-Effekt (giant magnetoresistance-Effekt) oder den AMR-Effekt (Anisotrope Magnetoresistive Effekt) oder den TMR-Effekt (Tunnel Magneto Resistance-Effekt) zeigt.

12. Elektrisches Bauteil mit mindestens zwei elektrischen Kontakten (3, 24, 34, 54, 64, 74) und auf einem Substrat (1, 22, 30, 40, 50, 60, 70) angeordneten Nanopartikeln (2, 10, 11) aus einem elektrisch leitfähigen Material, Nanopartikeln (2, 10, 11) aus einem magnetischen Material und/oder Nanopartikeln (2, 10, 11) aus einem magnetisierbaren Material, wobei
- die Nanopartikel (2, 10, 11) in einem oder mehreren Oberflächenbereichen des Substrats (1, 22, 30, 40, 50, 60, 70) auf dem Substrat (1, 22, 30, 40, 50, 60, 70) angeordnet sind,
- die Nanopartikel (2, 10, 11) innerhalb der Oberflächenbereiche in Form einer Gitterstruktur auf dem Substrat (1, 22, 30, 40, 50, 60, 70) angeordnet sind, wobei sich die Gitterstruktur der Nanopartikel (2, 10, 11) über den gesamten jeweiligen Oberflächenbereich erstreckt,
- der gesamte jeweilige Oberflächenbereich geometrisch in gleichförmige quadratische, aneinandergrenzende Teilbereiche (quadratische Pixel) oder geometrisch im wesentlichen durch gleichförmige kreisrunde oder ellipsenförmige, in einer Matrix nebeneinander angeordnete Teilbereiche (runde Pixel)aufgeteilt werden kann, und
- jeder quadratische Teilbereich eine Kantenlänge von weniger als 4 Millimeter, insbesondere bevorzugt von weniger als 1 Millimeter und ganz besonders bevorzugt von weniger als 100 Mikrometern oder jeder kreisrunde oder ellipsenförmige Teilbereich einen maximalen Durchmesser von weniger als 4 Millimeter, insbesondere bevorzugt von weniger als 1 Millimeter und ganz besonders bevorzugt von weniger als 100 Mikrometern aufweist,
- das elektrische Bauteil mit einem Verfahren hergestellt wurde, bei dem eine die Nanopartikel und/oder mit einer Hülle umgebene Nanopartikel enthaltende Tinte mittels eines Druckverfahrens auf das Substrat aufgebracht wird.

13. Elektrisches Bauteil nach Anspruch 12, **dadurch gekennzeichnet, daß** die Gitterstruktur der Nanopartikel (2, 10, 11) eine Monolage Nanopartikel (2, 10, 11) aufweist, die sich in einer horizontalen Ebene erstreckt.

14. Elektrisches Bauteil nach Anspruch 12, **dadurch gekennzeichnet, daß** die Gitterstruktur der Nanopartikel (2, 10, 11) mehrere übereinander angeordnete horizontale Ebenen aufweist.

15. Elektrisches Bauteil nach einem der Ansprüche 12 bis 14, **gekennzeichnet durch** eine Schutzschicht (4), die zumindest ein Nanopartikel (2, 10, 11) bedeckt.

16. Elektrisches Bauteil nach einem der Ansprüche 12 bis 15, **dadurch gekennzeichnet, dass** das Bauteil einen XMR-Effekt (X-MagnetoResistiv-Effekt), beispielsweise den GMR-Effekt (giant magnetoresistance-Effekt) oder den AMR-Effekt (Anisotrope Magnetoresistive Effekt) oder den TMR-Effekt (Tunnel Magneto Resistance-Effekt) zeigt.

## Claims

1. Method for producing an electric component having at least two electric contacts (3, 24, 34, 54, 64, 74) and having nanoparticles (2, 10, 11) which are arranged on a substrate (1, 22, 30, 40, 50, 60, 70) and made of an electrically conductive material, nanoparticles (2, 10, 11) made of a magnetic material and/or nanoparticles (2, 10, 11) made of a magnetisable material, in which an ink containing nanoparticles (2, 10, 11) surrounded by a cover is applied to the substrate (1, 22, 30, 40, 50, 60, 70) by means of a printing method,
**characterized in that**
the nanoparticles surrounded by a cover are surrounded by a ligand cover.

2. The production method according to Claim 1, **characterized in that** the nanoparticles (2, 10, 11) contained in the ink are substantially spherical.

3. The production method according to Claim 1 or 2, **characterized in that** the nanoparticles (2, 10, 11) contained in the ink have a substantially equal diameter and the standard deviation (SIGMA) of the nanoparticle diameter distribution is less than 10%, in particular preferably less than 5%.

4. The production method according to any one of Claims 1 to 3, **characterized in that** the nanoparticles (2, 10, 11) were created by the following method steps:
- production of seed crystals by reduction of metal salts or decomposition of organo-metallic compounds in a solvent,
- growth of the seed crystals and
- an Ostwald maturing process.

5. The production method according to Claim 5, **characterized in that** after the Ostwald maturing process a stabilisation of the nanoparticles created during the Ostwald maturing process is carried out.

6. The production method according to any one of Claims 1 to 5, **characterized in that** the ink comprises a solvent in which the nanoparticles (2, 10, 11) have been dissolved, and that the solvent is evaporated after the application of the ink to the substrate (1, 22, 30, 40, 50, 60, 70).

7. The production method according to any one of Claims 1 to 6, **characterized in that** the nanoparticles (2, 10, 11) in the ink occupy a volume greater than 49% of the total volume of the ink.

8. The production method according to any one of Claims 1 to 7, **characterized in that** an electrically conductive material is applied which connects at least one nanoparticle (2, 10, 11) to an electrical contact.

9. The production method according to any one of Claims 1 to 8, **characterized in that** at least one nanoparticle (2, 10, 11) contained in the ink has a cover and said cover is removed after the application of the ink to the substrate (1, 22, 30, 40, 50, 60, 70).

10. The production method according to any one of Claims 1 to 9, **characterized in that** a protective layer (4) is applied to at least one nanoparticle (2, 10, 11) after the application of the nanoparticle (2, 10, 11) to the substrate (1, 22, 30, 40, 50, 60, 70).

11. The production method according to any one of Claims 1 to 10, **characterized in that** a sensor is generated which exhibits an XMR effect (X magneto-resistive effect), for example the GMR effect (giant magneto-resistance effect) or the AMR effect (anisotropic magneto-resistive effect) or the TMR effect (tunnel magneto-resistance effect).

12. Electrical component having at least two electric contacts (3, 24, 34, 54, 64, 74) and nanoparticles (2, 10, 11) which are arranged on a substrate (1, 22, 30, 40, 50, 60, 70) and made of an electrically conductive material, nanoparticles (2, 10, 11) made of a magnetic material and/or nanoparticles (2, 10, 11) made of a magnetisable material, wherein
- the nanoparticles (2, 10, 11) are arranged on the substrate (1, 22, 30, 40, 50, 60, 70) in one or more surface regions of the substrate (1, 22, 30, 40, 50, 60, 70),
- the nanoparticles (2, 10, 11) are arranged within the surface regions in the form of a lattice structure on the substrate (1, 22, 30, 40, 50, 60, 70), wherein the lattice structure of the nanoparticles (2, 10, 11) extends over the whole of the respective surface region,
- the entire respective surface region can be divided geometrically into uniform square contiguous sub-regions (square pixels) or divided substantially geometrically by uniform circular or elliptical sub-regions (round pixels), arranged side by side in a matrix, and
- each square sub-region has an edge length of less than 4 mm, in particular preferably of less than 1 mm, and most preferably less than 100 microns, or each circular or elliptical sub-region has a maximum diameter of less than 4 mm, in particular preferably less than 1 mm, and most preferably less than 100 microns,
- the electrical component has been produced with a method in which an ink containing the nanoparticles and/or nanoparticles surrounded by a cover is applied to the substrate by means of a printing method.

13. Electric component according to Claim 12, **characterized in that** the lattice structure of the nanoparticles (2, 10, 11) comprises a monolayer nanoparticle (2, 10, 11) which extends in a horizontal plane.

14. Electric component according to Claim 12, **characterized in that** the lattice structure of the nanoparticles (2, 10, 11) has a plurality of horizontal planes arranged one above the other.

15. Electric component according to any one of Claims 12 to 14, **characterized by** a protective layer (4) which covers at least one nanoparticle (2, 10, 11).

16. Electric component according to any one of Claims 12 to 15, **characterized in that** the component exhibits an XMR effect (X magneto-resistive effect), for example the GMR effect (giant magneto-resistance effect) or the AMR effect (anisotropic magneto-resistive effect) or the TMR effect (tunnel magneto-resistance effect).

## Revendications

1. Procédé de fabrication d'un composant électrique comportant au moins deux contacts électriques (3, 24, 34, 54, 64, 74) et des nanoparticules (2, 10, 11) dans un matériau électriquement conducteur, des nanoparticules (2, 10, 11) dans un matériau magnétique et/ou des nanoparticules (2, 10, 11) dans un matériau magnétisable disposées sur un substrat (1, 22, 30, 40, 50, 60, 70), dans lequel une encre contenant des nanoparticules (2, 10, 11) entourées d'une enveloppe est appliquée sur le substrat (1, 22, 30, 40, 50, 60, 70) au moyen d'un procédé d'impression,
**caractérisé en ce**
**que** les nanoparticules entourées d'une enveloppe sont entourées d'une enveloppe de ligands.

2. Procédé de fabrication selon la revendication 1, **caractérisé en ce que** les nanoparticules (2, 10, 11) contenues dans l'encre sont sensiblement sphériques.

3. Procédé de fabrication selon la revendication 1 ou 2, **caractérisé en ce que** les nanoparticules (2, 10, 11) contenues dans l'encre présentent un diamètre sensiblement égal et que l'écart type (SIGMA) de la distribution du diamètre des nanoparticules est inférieur à 10 %, en particulier de préférence inférieur à 5 %.

4. Procédé de fabrication selon une des revendications 1 à 3, **caractérisé en ce que** les nanoparticules (2, 10, 11) ont été produites par les étapes de procédé suivantes :
- production de germes par réduction de sels métalliques ou une décomposition de composés organométalliques dans un solvant,
- croissance des germes et
- processus de maturation d'Ostwald.

5. Procédé de fabrication selon la revendication 5, **caractérisé en ce qu'**après le processus de maturation d'Ostwald, une stabilisation des nanoparticules produites pendant le processus de maturation d'Ostwald est effectuée.

6. Procédé de fabrication selon une des revendications 1 à 5, **caractérisé en ce que** l'encre présente un solvant dans lequel les nanoparticules (2, 10, 11) sont dissoutes et que le solvant est vaporisé après l'application de l'encre sur le substrat (1, 22, 30, 40, 50, 60, 70).

7. Procédé de fabrication selon une des revendications 1 à 6, **caractérisé en ce que** les nanoparticules (2, 10, 11) dans l'encre occupent une fraction volumique supérieure à 49 % du volume total de l'encre.

8. Procédé de fabrication selon une des revendications 1 à 7, **caractérisé en ce qu'**un matériau électriquement conducteur, qui relie au moins une nanoparticule (2, 10, 11) à un contact électrique, est appliqué.

9. Procédé de fabrication selon une des revendications 1 à 8, **caractérisé en ce qu'**au moins une nanoparticule (2, 10, 11) contenue dans l'encre présente une enveloppe et l'enveloppe est éliminée après l'application de l'encre sur le substrat (1, 22, 30, 40, 50, 60, 70).

10. Procédé de fabrication selon une des revendications 1 à 9, **caractérisé en ce qu'**une couche protectrice (4) est appliquée sur au moins une nanoparticule (2, 10, 11) après l'application de la nanoparticule (2, 10, 11) sur le substrat (1, 22, 30, 40, 50, 60, 70).

11. Procédé de fabrication selon une des revendications 1 à 10, **caractérisé en ce qu'**un capteur est produit, qui présente un effet XMR (effet magnétorésistif X), par exemple l'effet GMR (effet magnétorésistif géant), l'effet AMR (effet magnétorésistif anisotrope) ou l'effet TMR (effet de magnétorésistance tunnel).

12. Composant électrique comportant au moins deux contacts électriques (3, 24, 34, 54, 64, 74) et des nanoparticules (2, 10, 11) dans un matériau électriquement conducteur, des nanoparticules (2, 10, 11) dans un matériau magnétique et/ou des nanoparticules (2, 10, 11) dans un matériau magnétisable disposées sur un substrat (1, 22, 30, 40, 50, 60, 70), dans lequel
- les nanoparticules (2, 10, 11) sont disposées dans une ou plusieurs zones de surface du substrat (1, 22, 30, 40, 50, 60, 70) sur le substrat (1, 22, 30, 40, 50, 60, 70),
- les nanoparticules (2, 10, 11) sont disposées sous la forme d'une structure en treillis dans les zones de surface du substrat (1, 22, 30, 40, 50, 60, 70), la structure en treillis des nanoparticules (2, 10, 11) s'étendant sur toute la zone de surface respective,
- toute la zone de surface respective peut être divisée géométriquement en zones partielles uniformes carrées adjacentes (pixels carrés) ou géométriquement, sensiblement par des zones partielles uniformes circulaires ou ellipsoïdales, disposées les unes à côté des autres en une matrice (pixels circulaires), et
- chaque zone partielle carrée présente une longueur d'arête inférieure à 4 millimètres, en particulier de préférence inférieure à 1 millimètre et plus particulièrement de préférence inférieure à 100 microns ou chaque zone partielle circulaire ou ellipsoïdale un diamètre maximum inférieur à 4 millimètres, en particulier de préférence inférieur à 1 millimètre et plus particulièrement de préférence inférieur à 100 microns,
- le composant électrique a été fabriqué avec un procédé dans lequel une encre contenant les nanoparticules et/ou des nanoparticules entourées d'une enveloppe est appliquée sur le substrat au moyen d'un procédé d'impression.

13. Composant électrique selon la revendication 12, **caractérisé en ce que** la structure en treillis des nanoparticules (2, 10, 11) présente une monocouche de nanoparticules (2, 10, 11) qui s'étend dans un plan horizontal.

14. Composant électrique selon la revendication 12, **caractérisé en ce que** la structure en treillis des nanoparticules (2, 10, 11) présente plusieurs plans horizontaux disposés les uns au-dessus des autres.

15. Composant électrique selon une des revendications 12 à 14, **caractérisé par** une couche protectrice (4) qui recouvre au moins une nanoparticule (2, 10, 11).

16. Composant électrique selon une des revendications 12 à 15, **caractérisé en ce que** le composant présente un effet XMR (effet magnétorésistif X), par exemple l'effet GMR (effet magnétorésistif géant), l'effet AMR (effet magnétorésistif anisotrope) ou l'effet TMR (effet de magnétorésistance tunnel).
